(19) Europäisches Patentamt
European Patent Office
Office européen des brevets

(11) EP 3 318 414 A1

(12) **EUROPEAN PATENT APPLICATION**
published in accordance with Art. 153(4) EPC

(43) Date of publication:
**09.05.2018 Bulletin 2018/19**

(21) Application number: **16817749.1**

(22) Date of filing: **17.06.2016**

(51) Int Cl.:
***B41N 1/14*** *(2006.01)* ***B41N 1/00*** *(2006.01)*
***G03F 7/00*** *(2006.01)* ***G03F 7/09*** *(2006.01)*

(86) International application number:
**PCT/JP2016/068061**

(87) International publication number:
**WO 2017/002641 (05.01.2017 Gazette 2017/01)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **30.06.2015 JP 2015132081**

(71) Applicant: **FUJIFILM CORPORATION**
**Minato-ku**
**Tokyo 106-8620 (JP)**

(72) Inventor: **SHIMANAKA Shuji**
**Haibara-gun**
**Shizuoka 421-0396 (JP)**

(74) Representative: **Hoffmann Eitle**
**Patent- und Rechtsanwälte PartmbB**
**Arabellastraße 30**
**81925 München (DE)**

(54) **ORIGINAL PLATE FOR PRINTING, LITHOGRAPHIC PRINTING PLATE, DISPOSABLE PLATE FOR PRINTING, AND LAMINATE THEREOF**

(57) Provided is a printing plate precursor including: a support; a layer which contains a polymer on one side of the support; and a layer which contains a metal oxide obtained by hydrolyzing and polycondensing an organic metal compound or an inorganic metal compound and fine particles on the other side of the support, in which an average particle diameter of the fine particles is 0.3 μm or greater and is greater than the thickness of the layer containing a metal oxide and fine particles, and in a case where the printing plate precursors are laminated, dislocation in stacking precursors, adhesion between precursors, and scratches can be all prevented even without using interleaving paper.

FIG. 1

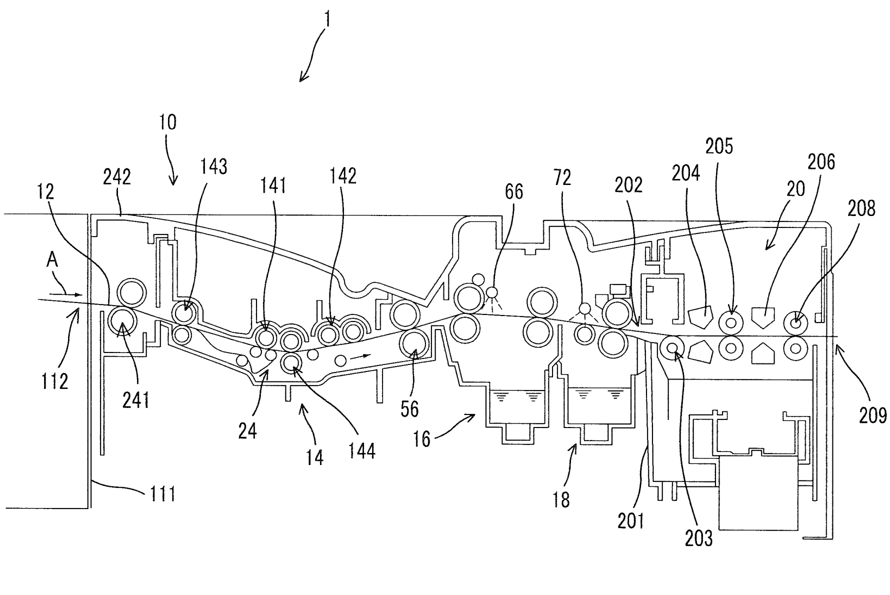


EP 3 318 414 A1

**Description**

**BACKGROUND OF THE INVENTION**

1. Field of the Invention

The present invention relates to a printing plate precursor which includes a planographic printing plate precursor and a blank plate precursor, a laminate thereof, a planographic printing plate and a blank plate for printing which are prepared using the printing plate precursor, and a laminate thereof.

2. Description of the Related Art

A planographic printing plate precursor is frequently stored and transported as a laminate formed by laminating a plurality of the planographic printing plate precursors. In this laminate, interleaving paper is typically inserted into the space between planographic printing plate precursors for the purpose of preventing dislocation in stacking of planographic printing plate precursors, preventing adhesion between planographic printing plate precursors, and preventing scratches on a surface of a planographic printing plate precursor on a recording layer side. However, in a case where interleaving paper is used, problems of cost increase, a disposal treatment, and the like may occur, and thus the interleaving paper needs to be removed before an exposure step. Therefore, this may also result in risk of occurrence of a load on a plate-making step and occurrence of interleaving paper peeling failure. Further, at the time of removing the interleaving paper, it is necessary to give consideration so that the surface of the planographic printing plate precursor on the recording layer side is not damaged. Accordingly, development of a planographic printing plate precursor that enables lamination without interleaving paper has been required.

For example, a planographic printing plate precursor (JP2007-148040A) which includes an organic polymer layer containing cross-linked polymer particles having a number average particle diameter of 1 to 100 μm on a surface opposite to a surface of a support having a recording layer; and a planographic printing plate material (JP2006-56185A) which is formed of polymer latex having a glass transition temperature (Tg) of 40°C or lower and on which a back coat layer that contains a matting agent having an average particle diameter of 10 μm or less is provided have been known. In addition, a planographic printing plate precursor (JP2008-249851A) which includes a photosensitive layer containing polymer fine particles and the like in one surface of a support and a back coat layer containing an organic polymer compound in a surface on the opposite side thereof has been known. In addition, a planographic printing plate precursor (JP2008-15503A) which includes a protective layer containing an organic resin fine particle whose surface is coated with a hydrophilic polymer and silica as an uppermost layer of a support on a recording layer side and a back coat layer formed of an organic resin on the opposite side thereof has been known.

SUMMARY OF THE INVENTION

However, in the technique described in JP2007-148040A, it was found that occurrence of scratches cannot be sufficiently prevented in some cases in a case where the Tg of the layer containing cross-linked polymer particles and an organic polymer is extremely high. Further, in JP2006-56185A, it was found that adhesion between precursors cannot be sufficiently prevented in some cases. Further, in the technique described in JP2008-249851A, the photosensitive layer contains organic resin fine particles, but the photosensitive layer greatly affects the performance of the planographic printing plate precursor, therefore, the performance of a planographic printing plate prepared from the planographic printing plate precursor, and thus it is essentially required that the performance of the planographic printing plate precursor, particularly, the image formability is not affected by the photosensitive layer and the fine particles do not fall off. Accordingly, it was found that the above-described performance needs to be considered and the range of design of the photosensitive layer is extremely limited in some cases in order for the photosensitive layer to contain organic resin fine particles.

Further, it was found that effects cannot be sufficiently obtained in a case where the technique described in JP2008-15503A is applied to an on-press development type planographic printing plate precursor or the like which includes a protective layer having a thickness that is extremely smaller than that of a protective layer of a wet development type planographic printing plate of the related art. The reason for this is considered to be that the organic resin fine particles cannot be sufficiently held so that the particles fall off from the protective layer.

An object of the present invention is to provide a printing plate precursor which is capable of preventing dislocation in stacking precursors, adhesion between precursors, and scratches even without interleaving paper in a case where printing plate precursors respectively including a planographic printing plate precursor and a blank plate precursor are laminated; and a laminate of the printing plate precursors.

Further, another object of the present invention is to provide a planographic printing plate or a blank plate for

printing prepared using the printing plate precursor; and a laminate of the planographic printing plates or the blank plates for printing.

The present invention includes the following configurations.

<1> A printing plate precursor comprising: a support; a layer which contains a polymer on one side of the support; and a layer which contains a metal oxide obtained by hydrolyzing and polycondensing an organic metal compound or an inorganic metal compound and fine particles on other side of the support, in which an average particle diameter of the fine particles is 0.3 μm or greater and is greater than a thickness of the layer containing the metal oxide and the fine particles.

<2> The printing plate precursor according to <1>, in which the fine particles are fine particles having a hydrophilic surface.

<3> The printing plate precursor according to <2>, in which the fine particles having a hydrophilic surface are at least one selected from organic resin fine particles having a hydrophilic surface and inorganic fine particles having a hydrophilic surface.

<4> The printing plate precursor according to <3>, in which the organic resin fine particles having a hydrophilic surface are organic resin fine particles coated with at least one inorganic compound selected from silica, alumina, titania, and zirconia.

<5> The printing plate precursor according to <3> or <4>, in which the organic resin fine particles having a hydrophilic surface are organic resin fine particles coated with silica.

<6> The printing plate precursor according to any one of <3> to <5>, in which an organic resin constituting the organic resin fine particles having a hydrophilic surface is at least one resin selected from a polyacrylic resin, a polyurethane resin, a polystyrene resin, a polyester resin, an epoxy resin, a phenolic resin, and a melamine resin.

<7> The printing plate precursor according to any one of <1> to <6>, in which the layer containing the polymer is a positive image recording layer containing an infrared absorbent.

<8> The printing plate precursor according to any one of <1> to <6>, in which the layer containing the polymer is a negative image recording layer containing an infrared absorbent, a polymerization initiator, and a polymerizable compound.

<9> The printing plate precursor according to any one of <1> to <6>, in which the layer containing the polymer is a negative image recording layer containing an infrared absorbent, a polymerization initiator, a polymerizable compound, and a polymer compound having a fine particle shape.

<10> The printing plate precursor according to any one of <1> to <6>, in which the layer containing the polymer is a negative image recording layer containing an infrared absorbent and thermoplastic polymer fine particles.

<11> The printing plate precursor according to any one of <7> to <10>, in which the layer containing the polymer is removable by at least any of printing ink and dampening water.

<12> The printing plate precursor according to any one of <1> to <6>, in which the layer containing the polymer is a non-photosensitive layer.

<13> The printing plate precursor according to <12>, in which the layer containing the polymer is removable by at least any of printing ink and dampening water.

<14> A planographic printing plate which is prepared using the printing plate precursor according to any one of <1> to <11>.

<15> A blank plate for printing which is prepared using the printing plate precursor according to <12> or <13>.

<16> A laminate which is formed by bringing a plurality of the printing plate precursors according to any one of <1> to <11> into direct contact with each other to laminate the printing plate precursors.

<17> A laminate which is formed by bringing a plurality of the printing plate precursors according to <12> or <13> into direct contact with each other to laminate the printing plate precursors.

<18> A laminate which is formed by bringing a plurality of the planographic printing plates according to <14> into direct contact with each other to laminate the planographic printing plates.

<19> A laminate which is formed by bringing a plurality of the blank plates for printing according to <15> into direct contact with each other to laminate the blank plates for printing.

Further, the present invention also includes the following configurations.

<20> A printing method comprising: image-exposing the printing plate precursor according to <11>; supplying printing ink and dampening water; and removing a non-image portion of the layer containing a polymer of the image recording layer on a printing press.

<21> A printing method comprising: supplying printing ink and dampening water and removing the layer containing a polymer on a printing press without image-exposing the printing plate precursor according to <12>.

According to the present invention, it is possible to provide a printing plate precursor which is capable of preventing dislocation in stacking precursors, adhesion between precursors, and scratches even without interleaving paper in a case where printing plate precursors respectively including a planographic printing plate precursor and a blank plate precursor are laminated; and a laminate of the printing plate precursors.

Further, according to the present invention, it is possible to provide a planographic printing plate or a blank plate for printing prepared using the printing plate precursor; and a laminate of the planographic printing plates or the blank plates for printing.

## BRIEF DESCRIPTION OF THE DRAWINGS

Fig. 1 is a view schematically illustrating an example of a configuration of an automatic developing device of a planographic printing plate precursor.

## DESCRIPTION OF THE PREFERRED EMBODIMENTS

Hereinafter, the present invention will be described in detail.

In the present specification the term "printing plate precursor" includes the planographic printing plate precursor and the blank plate precursor for printing. Further, the term "printing plate" includes the planographic printing plate and the blank plate for printing which are prepared by performing processes of exposure, development, and the like on the printing plate precursor. In a case of the blank plate precursor for printing, processes of exposure and development are not necessarily required.

A printing plate precursor according to the present invention includes a support; a layer which contains a polymer on one side of the support; and a layer which contains a metal oxide obtained by hydrolyzing and polycondensing an organic metal compound or an inorganic metal compound and fine particles on the other side of the support, in which the average particle diameter of the fine particles is 0.3 μm or greater and is greater than the thickness of the layer containing a metal oxide and fine particles.

The printing plate precursor according to the present invention includes a layer (hereinafter, also referred to as a back coat layer) which contains a metal oxide obtained by hydrolyzing and polycondensing an organic metal compound or an inorganic metal compound on the opposite side of the layer of the support that contains a polymer; and fine particles having a specific average particle diameter.

[Back coat layer]

The back coat layer in the printing plate precursor according to the present invention is a back coat layer which contains a metal oxide obtained by hydrolyzing and polycondensing an organic metal compound or an inorganic metal compound and fine particles. The average particle diameter of the fine particles is 0.3 μm or greater and is greater than the thickness of the layer containing a metal oxide and fine particles.

(Metal oxide obtained by hydrolyzing and polycondensing organic metal compound or inorganic metal compound)

The back coat layer contains a metal oxide obtained by hydrolyzing and polycondensing an organic metal compound or an inorganic metal compound.

It is preferable that the metal oxide (hereinafter, also simply referred to as the metal oxide) obtained by hydrolyzing and polycondensing an organic metal compound or an inorganic metal compound contained in the back coat layer is a so-called sol-gel reaction solution obtained by hydrolyzing and polycondensing an organic metal compound or an inorganic metal compound in water and an organic solvent using a catalyst such as an acid or an alkali.

Examples of the organic metal compound or the inorganic metal compound include a metal alkoxide, a metal acetylacetonate, a metal acetate, a metal oxalate, a metal nitrate, a metal sulfate, a metal carbonate, a metal oxychloride, a metal chloride, and a condensate obtained by partially hydrolyzing and oligomerizing these.

The metal alkoxide is a compound represented by $M(OR)_n$ (in the formula, M represents a metal element, R represents an alkyl group, and n represents the oxidation number of the metal element). Specific examples thereof include $Si(OCH3)_4$, $Si(OC_2H_5)_4$, $Si(OC_3H_7)4$, $Si(OC4H_9)_4$, $Al(OCH_3)_3$, $Al(OC_2H_5)_3$, $Al(OC_3H_7)_3$, $Al(OC_4H_9)_3$, $B(OCH_3)_3$, $B(OC_2H_5)_3$, $B(OC_3H_7)_3$, $B(OC_4H_9)_3$, $Ti(OCH_3)_4$, $Ti(OC_2H_5)_4$, $Ti(OC_3H_7)_4$, $Ti(OC_4H_9)_4$, $Zr(OCH3)4$, $Zr(OC_2H_5)_4$, $Zr(OC_3H_7)_4$, and $Zr(OC_4H_9)_4$; and other examples thereof include alkoxides of atoms such as Ge, Li, Na, Fe, Ga, Mg, P, Sb, Sn, Ta, and V. In addition, monosubstituted silicon alkoxides such as $CH_3Si(OCH_3)_3$, $C_2H_5Si(OCH_3)_3$, $CH_3Si(OC_2H_5)_3$, and $C_2H_5Si(OC2H_5)_3$ can be also used.

Among the organic metal compounds or the inorganic metal compounds, a metal alkoxide is preferable from the viewpoints of being rich in reactivity and easily generating a polymer from a metal-oxygen bond. Among the examples,

alkoxide compounds of silicon such as $Si(OCH_3)_4$, $Si(OC_2H_5)_4$, $Si(OC_3H_7)_4$, and $Si(OC_4H_9)_4$ are particularly preferable from the viewpoints of low cost, availability, and excellent coatability of metal oxides obtained from these. Further, oligomers obtained by hydrolyzing and condensing these alkoxide compounds of silicon are also preferable, and examples thereof include an ethyl silicate oligomer of an average pentamer oligomer which contains approximately 40% by mass of $SiO_2$.

The organic metal compound or the inorganic metal compound can be used alone or in combination of two or more kinds thereof.

Further, it is also preferable that a so-called silane coupling agent obtained by substituting one or two alkoxy groups in a tetraalkoxy compound of the silicon with an alkyl group or a group having reactivity is combined with a metal alkoxide. Examples of the silane coupling agent include a silane coupling agent obtained by substituting one or two alkoxy groups in a tetraalkoxy compound of the silicon with a hydrophobic substituent such as a long chain alkyl group having 4 to 20 carbon atoms or a fluorine-substituted alkyl group. Among these, a silane coupling agent containing a fluorine-substituted alkyl group is particularly preferable. Specific examples of the silane coupling agent include $CF_3CH_2CH_2Si(OCH_3)_3$, $CF_3CF_2CH_2CH_2Si(OCH_3)_3$, and $CF_3CH_2CH_2Si(OC_2H_5)_3$, and examples of the commercially available products thereof include LS-1090 (manufactured by Shin-Etsu Chemical Co., Ltd.). The content of the silane coupling agent is preferably in a range of 5% to 90% by mass and more preferably in a range of 10% to 80% by mass with respect to the total solid contents of the back coat layer.

As a catalyst useful for forming a sol-gel reaction solution, an organic or inorganic acid and an alkali are used. Examples thereof include an inorganic acid such as hydrochloric acid, sulfuric acid, sulfurous acid, nitric acid, nitrous acid, hydrofluoric acid, phosphoric acid, or phosphorous acid; an organic acid such as formic acid, acetic acid, propionic acid, butyric acid, glycolic acid, chloroacetic acid, dichloroacetic acid, trichloroacetic acid, fluoroacetic acid, bromoacetic acid, methoxyacetic acid, oxaloacetic acid, citric acid, oxalic acid, succinic acid, malic acid, tartaric acid, fumaric acid, maleic acid, malonic acid, ascorbic acid, benzoic acid, substituted benzoic acid such as 3,4-dimethoxybenzoic acid, phenoxyacetic acid, phthalic acid, picric acid, nicotinic acid, picolinic acid, pyrazine, pyrazole, dipicolinic acid, adipic acid, p-toluic acid, terephthalic acid, 1,4-cyclohexene-2,2-dicarboxylic acid, erucic acid, lauric acid, or n-undecanoic acid; and an alkali such as a hydroxide of an alkali metal or an alkaline earth metal, ammonia, ethanolamine, diethanolamine, or triethanolamine.

Other preferred examples of the catalyst include sulfonic acids, sulfinic acids, phosphonic acids, and phosphoric esters. Specifically, an organic acid such as p-toluenesulfonic acid, dodecylbenzenesulfonic acid, p-toluenesulfinic acid, ethyl acid, phenylphosphonic acid, phenylphosphinic acid, phenyl phosphate, or diphenyl phosphate can be used.

The catalyst can be used alone or in combination of two or more kinds thereof. The amount of the catalyst is preferably in a range of 0.001% to 10% by mass and more preferably in a range of 0.05% to 5% by mass with respect to the amount of the metal compound in a raw material. In a case where the amount of the catalyst is in the above-described range, the initiation of the sol-gel reaction is satisfactorily performed, a rapid reaction is suppressed, and generation of non-uniform sol-gel particles can be prevented.

An appropriate amount of water is required to initiate the sol-gel reaction. The amount of water to be added is preferably in a range of 0.05 to 50 molar times and preferably in a range of 0.5 to 30 molar times the amount to be required for completely hydrolyzing the metal compound in the raw material. In a case where the amount of water is in the above-described range, the hydrolysis proceeds satisfactorily.

A solvent is added to the sol-gel reaction solution. The solvent is not limited as long as the solvent dissolves the metal compound in the raw material and dissolves or disperses the sol-gel particles generated by the reaction, and examples thereof include lower alcohols such as methanol, ethanol, propanol, and butanol; and ketones such as acetone, methyl ethyl ketone, and diethyl ketone. Further, mono- or dialkyl ether or acetic acid ester of glycols such as ethylene glycol, diethylene glycol, triethylene glycol, propylene glycol, or dipropylene glycol can be used for the purpose of improving the quality of the coating surface of the back coat layer. As the solvent, lower alcohols which can be mixed with water are preferable. The concentration of the sol-gel reaction solution is adjusted to be suitable for coating using a solvent, but the hydrolysis reaction is unlikely to proceed because the raw material is diluted in a case where the total amount of solvent is added to the reaction solution from the beginning. Therefore, a method of adding a part of the solvent to the sol-gel reaction solution and then adding the remaining solvent after the reaction proceeds is preferable.

(Fine particles)

The back coat layer contains fine particles.

The average particle diameter of fine particles contained in the back coat layer is 0.3 μm or greater and is greater than the thickness of the back coat layer.

It is preferable that the fine particles are fine particles respectively having a hydrophilic surface. The fine particles respectively having a hydrophilic surface include organic resin fine particles having a hydrophilic surface or inorganic fine particles having a hydrophilic surface.

It is preferable that the organic resin fine particles respectively having a hydrophilic surface are organic resin fine particles coated with at least one inorganic compound selected from silica, alumina, titania, and zirconia. Organic resin fine particles coated with silica are particularly preferable.

It is preferable that an organic resin constituting organic resin fine particles respectively having a hydrophilic surface is at least one resin selected from a polyacrylic resin, a polyurethane-based resin, a polystyrene-based resin, a polyester-based resin, an epoxy-based resin, a phenolic resin, and a melamine resin.

Hereinafter, the organic resin fine particles respectively having a hydrophilic surface will be described in detail using organic resin fine particles coated with silica (hereinafter, also referred to as silica-coated organic resin fine particles) as an example, but the organic resin fine particles respectively having a hydrophilic surface in the present invention are not limited thereto.

(Silica-coated organic resin fine particles)

The silica-coated organic resin fine particle is a fine particle which is formed of an organic resin and has a surface coated with silica. It is preferable that organic resin fine particles constituting the core are not softened or become sticky due to the moisture in air or the temperature.

Examples of the organic resin constituting the organic resin fine particles of the silica-coated organic resin fine particles include a polyacrylic resin, a polyurethane-based resin, a polystyrene-based resin, a polyester-based resin, an epoxy-based resin, a phenol resin, and a melamine resin.

As a material forming the silica layer covering the surface of the silica-coated organic resin fine particle, a compound containing an alkoxysilyl group such as a condensate of an alkoxysiloxane-based compound, particularly, a siloxane-based material, and specifically, silica fine particles such as silica sol, colloidal silica, and silica nanoparticles are preferable exemplified.

The configuration of the silica-coated organic resin fine particle may be a configuration in which a silica fine particle adheres to the surface of an organic resin fine particle as a solid component or a configuration in which a siloxane-based compound layer is formed on the surface of an organic resin fine particle by performing a condensation reaction on an alkoxysiloxane-based compound.

Silica does not necessarily cover the entire surface of the organic resin fine particle, and the effects of the present invention can be easily obtained in a case where the surface thereof is coated with at least 0.5% by mass or greater of silica with respect to the mass of the organic resin fine particles. In other words, in a case where silica is present on at least a part of the surface of the organic resin fine particle, improvement in affinity for a coexisting water-soluble polymer such as PVA is achieved, falling off of the fine particle is suppressed even in a case where external stress is applied thereto, and excellent scratch resistance and adhesion resistance can be maintained. Accordingly, the expression "coated with silica" in the present invention includes a state in which silica is present on at least a part of the surface of the organic resin fine particle as described above.

The state of the surface being coated with silica can be confirmed by morphological observation using a scanning electron microscope (TEM) or the like. Further, the coating amount of silica can be confirmed by detecting Si atoms through elemental analysis such as fluorescent X-ray analysis and calculating the amount of silica present therein.

A method of producing silica-coated organic resin fine particles is not particularly limited, and examples thereof include a method of forming a silica surface coating layer simultaneously with formation of organic resin fine particles by allowing silica fine particles or a silica precursor compound to coexist with a monomer component which becomes the raw material of the organic resin fine particles; and a method of forming organic resin fine particles, physically adhering silica fine particles to each surface of the organic resin fine particles, and fixing the silica fine particles thereto.

Hereinafter, an example of the method of producing silica-coasted organic resin fine particles will be described. First, silica and a raw material resin (more specifically, a raw material resin such as a monomer capable of suspension polymerization, a prepolymer capable of suspension cross-linking, or a resin liquid, constituting the above-described organic resin) are added to water containing a suspension stabilizer appropriately selected from a water-soluble polymer such as polyvinyl alcohol, methyl cellulose, or polyacrylic acid and an inorganic suspending agent such as calcium phosphate or calcium carbonate, and stirred and mixed with the water to prepare a suspension in which silica and a raw material resin are dispersed. At this time, a suspension having a target particle diameter can be formed by adjusting the type, the concentration, and the stirring rotation speed of the suspension stabilizer. Next, the suspension is heated to start the reaction, and resin particles are generated by performing suspension polymerization or suspension cross-linking on the resin raw material. At this time, the coexisting silica is fixed to the resin particle cured by the polymerization or the cross-linking reaction, particularly, the vicinity of the surface of the resin particle due to the physical properties thereof. Thereafter, the suspension is subjected to solid-liquid separation, the suspension stabilizer adhering to the particles is removed by washing, and the particles are dried. In this manner, silica-coated organic resin fine particles to which silica is fixed and which have a desired particle diameter and a substantially spherical shape can be obtained.

As described above, silica-coated organic resin fine particles having a desired particle diameter can be obtained

by controlling the conditions during the suspension polymerization or the suspension cross-linking or silica-coated organic resin fine particles are generated without strictly controlling the conditions and then silica-coated organic fine particles having a desired size can be obtained by a mesh filtration method or the like.

In regard to the amount of the raw material to be added to the mixture during the production of the silica-coated organic fine particles according to the above-described method, in a case where the total amount of the raw material resin and the silica is 100 parts by weight, first, 0.1 to 20 parts by weight of the suspension stabilizer is added to 200 to 800 parts by weight of water serving as a dispersion medium, and sufficiently dissolved or dispersed therein, 100 parts by weight of a mixture of the raw material resin and the silica is put into the solution, the solution is stirred while the stirring speed is adjusted such that the dispersed particles have a predetermined particle size, and the solution temperature is increased to 30°C to 90°C after the adjustment of the particle size to cause a reaction for 1 to 8 hours.

The above-described method is merely an example of the method of producing silica-coated organic resin fine particles and silica-coated organic resin fine particles obtained by the methods specifically described in JP2002-327036A, JP2002-173410A, JP2004-307837A, JP2006-38246A, and the like can be also suitably used in the present invention.

Further, the silica-coated organic resin fine particles are also available as commercially available products, and specific examples of silica-melamine composite fine particles include OPTBEADS 2000M, OPTBEADS 3500M, OPTBEADS 6500M, OPTBEADS 10500M, OPTBEADS 3500S, and OPTBEADS 6500S (all manufactured by Nissan Chemical Industries, Ltd.). Specific examples of silica-acrylic composite fine particles include ART PEARL G-200 transparent, ART PEARL G-400 transparent, ART PEARL G-800 transparent, ART PEARL GR-400 transparent, ART PEARL GR-600 transparent, ART PEARL GR-800 transparent, and ART PEARL J-7P (all manufactured by Negami Chemical Industrial Co., Ltd.). Specific examples of silica-urethane composite fine particles include ART PEARL C-400, C-800 transparent, P-800T, U-600T, U-800T, CF-600T, CF800T (all manufactured by Negami Chemical Industrial Co., Ltd.) and DYNAMIC BEADS CN5070D and DANPLACOAT THU (both manufactured by Dainichiseika Color & Chemicals Mfg. Co., Ltd.).

Hereinbefore, the organic resin fine particles used for the back coat layer of the present invention have been described using the example of the silica-coated organic resin fine particles, and the same applies to organic resin fine particles coated with alumina, titania, or zirconia by using alumina, titania, or zirconia in place of silica.

As inorganic fine particles having a hydrophilic surface, known inorganic particles having a hydrophilic surface can be used. Particularly, fine particles formed of silica, alumina, zirconia, or titania are preferable.

As the fine particles contained in the back coat layer, organic resin fine particles can be used. Preferred examples of the organic resin fine particles include fine particles formed of synthetic resins such as poly(meth)acrylic acid esters, polystyrene and a derivative thereof, polyamides, polyimides, polyolefins such as low-density polyethylene, high-density polyethylene, and polypropylene, polyurethane, polyurea, and polyesters; and fine particles formed of natural polymers such as chitin, chitosan, cellulose, cross-linked starch, and cross-linked cellulose.

Among these, synthetic resin fine particles have advantages of easily controlling the particle size and easily controlling desired surface characteristics through surface modification.

Among examples of the method of producing organic resin fine particles, a method of atomization according to a crushing method can be used in a case of a relatively hard resin such as polymethyl methacrylate (PMMA), but a method of synthesizing particles according to an emulsification and suspension polymerization method is preferably employed from the viewpoints of the precision and ease of controlling the particle diameter.

The method of producing organic resin fine particles is specifically described in "Ultrafine Particles and Materials" edited by Materials Science Society of Japan, published by SHOKABO Co., Ltd., in 1993 and "Preparation and Application of Fine Particles and Powder" supervised by Haruma Kawaguchi, published by CMC Publishing Co., Ltd., in 2005.

The organic resin fine particles are also available as commercially available products, and examples thereof include cross-linked acrylic resins such as MX-300, MX-500, MX-1000, MX-1500H, MR-2HG, MR-7HG, MR-10HG, MR-3GSN, MR-5GSN, MR-7G, MR-10G, MR-5C, and MR-7GC; styryl resins such as SX-350H and SX-500H (all manufactured by Soken Chemical & Engineering Co., Ltd.); acrylic resins such as MBX-5, MBX-8, MBX-12, MBX-15, MBX-20, MB20X-5, MB30X-5, MB30X-8, MB30X-20, SBX-6, SBX-8, SBX-12, and SBX-17 (all manufactured by Sekisui Plastics Co., Ltd.); and polyolefin resins such as CHEMIPEARL W100, W200, W300, W308, W310, W400, W401, W405, W410, W500, WF640, W700, W800, W900, W950, and WP100 (all manufactured by Mitsui Chemicals, Inc.)

As the shape of fine particles used for the back coat layer, a perfectly spherical shape is preferable, and a flat plate shape or a so-called spindle shape in which a projection view is in an elliptical shape may be employed.

It is important that the average particle diameter of the fine particles is greater than the thickness of the back coat layer. It is preferable that the average particle diameter of fine particles is greater than the thickness of the back coat layer by 0.3 μm or greater.

The average particle diameter of fine particles is preferably in a range of 0.3 to 30 μm, more preferably in a range of 0.5 to 15 μm, and still more preferably in a range of 1 to 10 μm. In a case where the average particle diameter thereof is in the above-described range, a spacer function can be sufficiently exhibited, the fine particles are easily fixed to the back coat layer, and an excellent holding function with respect to contact stress from the outside is exhibited.

The average particle diameter of the fine particles of the present invention indicates the volume average particle diameter which has been typically used, and the volume average particle diameter can be measured using a laser diffraction and scattering type particle size distribution meter. Examples of the measuring device include a particle size distribution measuring device "Microtrac MT-3300II" (manufactured by Nikkiso Co., Ltd.).
The amount of silica-coated fine particles to be added to the back coat layer is preferably in a range of 5 to 1000 mg/$m^2$, more preferably in a range of 10 to 500 mg/$m^2$, and still more preferably in a range of 20 to 200 mg/$m^2$.
As necessary, other additives such as a fluorine-based may be added to the back coat layer for improving the coating properties of the back coat layer, other surfactants may be added thereto for adjusting slipping properties, and dyes or pigments may be added thereto for coloring and determining the plate type. These additives are specifically described in paragraphs [0030] to [0036] of JP1994-234284A (JP-H06-234284A).
The thickness of the back coat layer is preferably in a range of 0.01 to 30 μm, more preferably in a range of 0.1 to 10 μm, and still more preferably in a range of 0.2 to 5 μm. Further, the thickness of the back coat layer is required to be greater than the average particle diameter of the fine particles contained therein.
The thickness of the back coat layer can be measured by coating the surface of a support to be coated with a back coat layer to form a back coat layer, observing the cross section of the back coat layer using a scanning electron microscope (SEM), measuring the film thicknesses of five sites in a smooth region where fine particles are not present, and then acquiring the average value thereof.
The back coat layer can be prepared by adjusting the metal oxide and fine particles and a back coat layer coating solution containing other additives as necessary, coating the support with the back coat layer coating solution, and drying the support. The support is coated with the back coat layer according to a known coating method such as bar coater coating. The support is dried in a temperature range of 50°C to 200°C for 10 seconds to 5 minutes.

[Printing plate precursor]

The printing plate precursor of the present invention includes a layer containing a polymer on one surface of the support.
Hereinafter, a planographic printing plate precursor which is a preferred embodiment of the printing plate precursor will be described.

[Planographic printing plate precursor]

The planographic printing plate precursor of the present invention has an image recording layer on a support. The image recording layer of the planographic printing plate precursor corresponds to the layer containing a polymer in the printing plate precursor. The image recording layer of the planographic printing plate precursor may have an undercoat layer between the support and the image recording layer and a protective layer on the image recording layer as necessary.

[Image recording layer]

According to one preferred embodiment, the image recording layer is an image recording layer in which the non-image portion is removed by at least one of acidic to alkaline dampening water or printing ink on a printing press.
According to one embodiment, the image recording layer is a negative type image recording layer (hereinafter, also referred to as an image recording layer A) that contains an infrared absorbent, a polymerization initiator, a polymerizable compound, and a binder polymer.
According to another embodiment, the image recording layer is a negative image recording layer (hereinafter, also referred to as an image recording layer B) that contains an infrared absorbent, a polymerization initiator, a polymerizable compound, and a particulate polymer compound.
According to still another embodiment, the image recording layer is a negative image recording layer (hereinafter, also referred to as an image recording layer C) that contains an infrared absorbent and thermoplastic polymer fine particles.

(Image recording layer A)

The image recording layer A contains an infrared absorbent, a polymerization initiator, a polymerizable compound, and a binder polymer. Hereinafter, the constituent components of the image recording layer A will be described.

<Infrared absorbent>

An infrared absorbent has a function of converting absorbed infrared rays into heat, a function of electron

transfer to a polymerization initiator described below through excitation by infrared rays, and/or a function of energy transfer. As the infrared absorbent used in the present invention, a dye or a pigment having maximum absorption at a wavelength of 760 to 1,200 nm is preferable and a dye having maximum absorption at a wavelength of 760 to 1,200 nm is more preferable.

As the dye, dyes described in paragraphs [0082] to [0088] of JP2014-104631A can be used.

The particle diameter of the pigment is preferably in a range of 0.01 to 1 μm and more preferably in a range of 0.01 to 0.5 μm, A known dispersion technique used to produce inks or toners can be used for dispersion of the pigment. The details are described in "Latest Pigment Application Technology" (CMC Publishing Co., Ltd., 1986) and the like.

The infrared absorbent may be used alone or in combination of two or more kinds thereof.

The content of the infrared absorbent is preferably in a range of 0.05 to 30 parts by mass, more preferably in a range of 0.1 to 20, and particularly preferably in a range of 0.2 to 10 parts by mass with respect to 100 parts by mass of the total solid content of the image recording layer.

<Polymerization initiator>

The polymerization initiator indicates a compound that initiates and promotes polymerization of a polymerizable compound. As the polymerization initiator, a known thermal polymerization initiator, a compound having a bond with small bond dissociation energy, or a photopolymerization initiator can be used. Specifically, radical polymerization initiators described in paragraphs [0092] to [0106] of JP2014-104631A can be used.

Preferred examples of compounds in the polymerization initiators include onium salts such as iodonium salts and sulfonium salts. Specific preferred examples of the compounds in each of the salts are the compounds described in paragraphs [0104] to [0106] of JP2014-104631A.

The content of the polymerization initiator is preferably in a range of 0.1% to 50% by mass, more preferably in a range of 0.5% to 30% by mass, and particularly preferably in a range of 0.8% to 20% by mass with respect to the total solid content of the image recording layer. When the content thereof is in the above-described range, improved sensitivity and improved stain resistance of a non-image portion at the time of printing are obtained.

<Polymerizable compound>

A polymerizable compound is an addition polymerizable compound having at least one ethylenically unsaturated double bond and is selected from compounds having at least one and preferably two or more terminal ethylenically unsaturated bonds. These have chemical forms such as a monomer, a pre-polymer, that is, a dimer, a trimer, an oligomer, and a mixture of these. Specifically, polymerizable compounds described in paragraphs [0109] to [0113] of JP2014-104631A can be used.

Among the examples described above, from the viewpoint that the balance between hydrophilicity associated with on-press developability and polymerization ability associated with printing durability is excellent, isocyanuric acid ethylene oxide-modified acrylates such as tris(acryloyloxyethyl) isocyanurate and bis(acryloyloxyethyl)hydroxyethyl isocyanurate are particularly preferable.

The details of the structures of these polymerizable compounds, whether to be used alone or in combination, and the usage method such as the addition amount can be arbitrarily set according to the final performance design of a planographic printing plate precursor. The content of the above-described polymerizable compound to be used is preferably in a range of 5% to 75% by mass, more preferably in a range of 10% to 70% by mass, and particularly preferably in a range of 15% to 60% by mass with respect to the total solid content of the image recording layer.

<Binder polymer>

A binder polymer can be mainly used to improve the film hardness of the image recording layer. As the binder polymer, known polymers of the related art can be used and polymers having coated-film properties are preferable. Among examples thereof, an acrylic resin, a polyvinyl acetal resin, and a polyurethane resin are preferable.

Preferred examples of the binder polymers include polymers having a cross-linking functional group in the main or side chain, preferably in the side chain, for improving coated-film strength of an image portion as described in JP2008-195018A. Cross-linking occurs between polymer molecules by a cross-linking group so that curing is promoted.

Preferred examples of the cross-linking functional group include an ethylenically unsaturated group such as a (meth)acryl group, a vinyl group, an allyl group, or a styryl group and an epoxy group, and the cross-linking functional groups can be introduced into a polymer by a polymer reaction or copolymerization. For example, a reaction between an acrylic polymer having a carboxy group in the side chain thereof or polyurethane and glycidyl methacrylate or a reaction between a polymer having an epoxy group and ethylenically unsaturated group-containing carboxylic acid such as methacrylic acid can be used.

The content of the cross-linking group in the binder polymer is preferably in a range of 0.1 to 10.0 mmol, more preferably in a range of 0.25 to 7.0 mmol, and particularly preferably in a range of 0.5 to 5.5 mmol with respect to 1 g of the binder polymer.

Moreover, it is preferable that the binder polymer includes a hydrophilic group. The hydrophilic group contributes to providing on-press developability for the image recording layer. Particularly, in the coexistence of a cross-linking group and a hydrophilic group, both of printing durability and on-press developability can be achieved.

Examples of the hydrophilic group include a hydroxy group, a carboxy group, an alkylene oxide structure, an amino group, an ammonium group, an amide group, a sulfo group, and a phosphoric acid group. Among these, an alkylene oxide structure having 1 to 9 alkylene oxide units having 2 or 3 carbon atoms is preferable. A monomer having a hydrophilic group may be copolymerized in order to provide a hydrophilic group for a binder polymer.

In addition, in order to control the impressing property, a lipophilic group such as an alkyl group, an aryl group, an aralkyl group, or an alkenyl group can be introduced into the binder polymer. For example, a lipophilic group-containing monomer such as methacrylic acid alkyl ester may be copolymerized.

The weight-average molecular weight (Mw) of the binder polymer is preferably 2,000 or greater, more preferably 5,000 or greater, and still more preferably in a range of 10,000 to 300,000.

The content of the binder polymer is practically in a range of 3% to 90% by mass, preferably in a range of 5% to 80% by mass, and more preferably in a range of 10% to 70% by mass with respect to the total solid content of the image recording layer.

As a preferred example of the binder polymer, a polymer compound having a polyoxyalkylene chain in the side chain is exemplified. When the image recording layer contains a polymer compound having a polyoxyalkylene chain in the side chain (hereinafter, also referred to as a POA chain-containing polymer compound), permeability of dampening water is promoted and on-press developability is improved.

Examples of the resin constituting the main chain of the POA chain-containing polymer compound include an acrylic resin, a polyvinyl acetal resin, a polyurethane resin, a polyurea resin, a polyimide resin, a polyamide resin, an epoxy resin, a methacrylic resin, a polystyrene resin, a novolac type phenolic resin, a polyester resin, synthetic rubber, and natural rubber. Among these, an acrylic resin is particularly preferable.

The POA chain-containing polymer compound does not substantially contain a perfluoroalkyl group. The expression "does not substantially contain a perfluoroalkyl group" means that the mass ratio of a fluorine atom present as a perfluoroalkyl group in a polymer compound is less than 0.5% by mass, and it is preferable that the polymer compound does not contain a fluorine atom. The mass ratio of the fluorine atom is measured by an elemental analysis method.

In addition, the "perfluoroalkyl group" is a group in which all hydrogen atoms of the alkyl group are substituted with fluorine atoms.

As alkylene oxide (oxyalkylene) in a polyoxyalkylene chain, alkylene oxide having 2 to 6 carbon atoms is preferable, ethylene oxide (oxyethylene) or propylene oxide (oxypropylene) is more preferable, and ethylene oxide is still more preferable.

The repetition number of the alkylene oxide in a polyoxyalkylene chain, that is, a poly(alkyleneoxide) moiety is preferably in a range of 2 to 50 and more preferably in a range of 4 to 25.

When the repetition number of the alkylene oxide is 2 or greater, the permeability of dampening water is sufficiently improved. Further, from the viewpoint that printing durability is not degraded due to abrasion, it is preferable that the repetition number thereof is 50 or less.

As the poly(alkyleneoxide) moiety, structures described in paragraphs [0060] to [0062] of JP2014-104631A are preferable.

The POA chain-containing polymer compound may have cross-linking properties in order to improve coated-film strength of an image portion. Examples of the POA chain-containing polymer compounds having cross-linking properties are described in paragraphs [0063] to [0072] of JP2014-104631A.

The proportion of repeating units having a poly(alkyleneoxide) moiety in the total repeating units constituting the POA chain-containing polymer compound is not particularly limited, but is preferably in a range of 0.5% to 80% by mole and more preferably in a range of 0.5% to 50% by mole. Examples of the POA chain-containing polymer compounds are described in paragraphs [0075] and [0076] of JP2014-104631A.

As the POA chain-containing polymer compound, hydrophilic macromolecular compounds such as polyacrylic acid and polyvinyl alcohol described in JP2008-195018A can be used in combination as necessary. Further, a lipophilic polymer compound and a hydrophilic macromolecular compound can be used in combination.

In addition to the presence of the POA chain-containing polymer compound in the image recording layer as a binder that plays a role of connecting image recording layer components with each other, the specific polymer compound may be present in the form of fine particles. In a case where the specific polymer compound is present in the form of fine particles, the average particle dimeter is in a range of 10 to 1,000 nm, preferably in a range of 20 to 300 nm, and particularly preferably in a range of 30 to 120 nm.

The content of the POA chain-containing polymer compound is preferably in a range of 3% to 90% by mass

and more preferably in a range of 5% to 80% by mass with respect to the total solid content of the image recording layer. When the content thereof is in the range of 3% to 90% by mass, both of permeability of dampening water and image formability can be reliably achieved.

Other preferred examples of the binder polymer include a polymer compound (hereinafter, also referred to as a "star type polymer compound") which has a polymer chain bonded to a nucleus through a sulfide bond by means of using a polyfunctional, in a range of hexa- to deca-functional, thiol as the nucleus and in which the polymer chain has a polymerizable group. As the star type polymer compound, for example, compounds described in JP2012-148555A can be preferably used.

Examples of the star type polymer compound include compounds having a polymerizable group such as an ethylenically unsaturated bond in the main chain or in the side chain, preferably in the side chain, for improving coated-film strength of an image portion as described in JP2008-195018A. Cross-linking occurs between polymer molecules by a polymerizable group so that curing is promoted.

Preferred examples of the polymerizable group include an ethylenically unsaturated group such as a (meth)acryl group, a vinyl group, an allyl group, or a styryl group and an epoxy group. Among these, from the viewpoint of polymerization reactivity, a (meth)acryl group, a vinyl group, or a styryl group is more preferable and a (meth)acryl group is particularly preferable. These groups can be introduced into a polymer by a polymer reaction or copolymerization. For example, a reaction between a polymer having a carboxy group in the side chain thereof and glycidyl methacrylate or a reaction between a polymer having an epoxy group and ethylenically unsaturated group-containing carboxylic acid such as methacrylic acid can be used. These groups may be used in combination.

The content of the cross-linking group in the star type polymer compound is preferably in a range of 0.1 to 10.0 mmol, more preferably in a range of 0.25 to 7.0 mmol, and most preferably in a range of 0.5 to 5.5 mmol with respect to 1 g of the star type polymer compound.

Moreover, it is preferable that the star type polymer compound further includes a hydrophilic group. The hydrophilic group contributes to providing on-press developability for the image recording layer. Particularly, in the coexistence of a polymerizable group and a hydrophilic group, both of printing durability and developability can be achieved.

Examples of the hydrophilic group include $-SO_3M^1$, -OH, $-CONR^1R^2$ ($M^1$ represents hydrogen, a metal ion, an ammonium ion, or a phosphonium ion, $R^1$ and $R^2$ each independently represent a hydrogen atom, an alkyl group, an alkenyl group, or an aryl group, and $R^1$ and $R^2$ may be bonded to each other to form a ring), $-N^+R^3R^4R^5X^-$ ($R^3$ to $R^5$ each independently represent an alkyl group having 1 to 8 carbon atoms and $X^-$ represents a counter anion), a group represented by the following Formula (1), and a group represented by the following Formula (2).

$-(CH_2CH_2O)_nR$ Formula (1)

$-(C_3H_6O)_mR$ Formula (2)

In the above-described formulae, n and m each independently represent an integer of 1 to 100 and R's each independently represent a hydrogen atom or an alkyl group having 1 to 18 carbon atoms.

Here, in a case where the star type polymer compound is a star type polymer compound having a polyoxyalkylene chain (for example, a group represented by the above-described Formula (1) or (2)) in the side chain, such a star type polymer compound is a polymer compound having the above-described polyoxyalkylene chain in the side chain.

Among these hydrophilic groups, $-CONR^1R^2$, groups represented by Formula (1), and groups represented by Formula (2) are preferable, $-CONR^1R^2$ and groups represented by Formula (1) are more preferable, and groups represented by Formula (1) are particularly preferable. Among the groups represented by Formula (1), n represents an integer of preferably 1 to 10 and particularly preferably 1 to 4. Further, R represents more preferably a hydrogen atom or an alkyl group having 1 to 4 carbon atoms and particularly preferably a hydrogen atom or a methyl group. These hydrophilic groups may be used in combination of two or more kinds thereof.

Further, it is preferable that the star type polymer compound does not substantially include a carboxylic acid group, a phosphoric acid group, or a phosphonic acid group. Specifically, the amount of these acid groups is preferably less than 0.1 mmol/g, more preferably less than 0.05 mmol/g, and particularly preferably 0.03 mmol/g or less. When the amount of these acid groups is less than 0.1 mmol/g, developability is further improved.

In order to control impressing properties, a lipophilic group such as an alkyl group, an aryl group, an aralkyl group, or an alkenyl group can be introduced to the star type polymer compound. Specifically, a lipophilic group-containing monomer such as methacrylic acid alkyl ester may be copolymerized.

Specific examples of the star type polymer compound include compounds described in paragraphs [0153] to [0157] of JP2014-104631A.

The star type polymer compound can be synthesized, using a known method, by performing radical polymerization on the above-described monomers constituting a polymer chain in the presence of the above-described polyfunctional thiol compound.

The weight-average molecular weight (Mw) of the star type polymer compound is preferably in a range of 5,000 to 500,000, more preferably in a range of 10,000 to 250,000, and particularly preferably in a range of 20,000 to 150,000. When the weight-average molecular weight thereof is in the above-described range, the on-press developability and the printing durability are more improved.
The star type polymer compound may be used alone or in combination of two or more kinds thereof. Further, the star type polymer compound may be used in combination with a typical linear binder polymer.
The content of the star type polymer compound is preferably in a range of 5% to 95% by mass, more preferably in a range of 10% to 90% by mass, and particularly preferably in a range of 15% to 85% by mass with respect to the total solid content of the image recording layer.
From the viewpoint of promoting the permeability of dampening water and improving the on-press developability, star type polymer compounds described in JP2012-148555A are particularly preferable.

<Other components>

The image recording layer A can contain other components described below.

(1) Low-molecular weight hydrophilic compound

In order to improve the on-press developability without degrading the printing durability, the image recording layer may contain a low-molecular weight hydrophilic compound.
As the low-molecular weight hydrophilic compound, examples of a water-soluble organic compound include glycols such as ethylene glycol, diethylene glycol, triethylene glycol, propylene glycol, dipropylene glycol, and tripropylene glycol and ether or ester derivatives thereof; polyols such as glycerin, pentaerythritol, and tris(2-hydroxyethyl) isocyanurate; organic amines such as triethanolamine, diethanolamine, and monoethanolamine and salts thereof; organic sulfonic acids such as alkylsulfonic acid, toluenesulfonic acid, and benzenesulfonic acid and salts thereof; organic sulfamic acids such as alkyl sulfamic acid and salts thereof; organic sulfuric acids such as alkyl sulfuric acid and alkyl ether sulfuric acid and salts thereof; organic phosphonic acids such as phenyl phosphonic acid and salts thereof; organic carboxylic acids such as tartaric acid, oxalic acid, citric acid, malic acid, lactic acid, gluconic acid, and amino acids and salts thereof; and betaines.
Among these, it is preferable that the image recording layer contains at least one selected from the group consisting of polyols, organic sulfates, organic sulfonates, and betaines.
Specific examples of the compounds of the organic sulfonates include compounds described in paragraphs [0026] to [0031] of JP2007-276454A and paragraphs [0020] to [0047] of JP2009-154525A. The salt may be potassium salt or lithium salt.
Examples of the organic sulfate include compounds described in paragraphs [0034] to [0038] of JP2007-276454A.
As betaines, compounds having 1 to 5 carbon atoms of hydrocarbon substituents to nitrogen atoms are preferable. Specific examples thereof include trimethyl ammonium acetate, dimethyl propyl ammonium acetate, 3-hydroxy-4-trimethyl ammonio butyrate, 4-(1-pyridinio)butyrate, 1-hydroxyethyl-1-imidazolioacetate, trimethyl ammonium methane sulfonate, dimethyl propyl ammonium methane sulfonate, 3-trimethylammonio-1-propane sulfonate, and 3-(1-pyridinio)-1-propane sulfonate.
Since the low-molecular weight hydrophilic compound has a small structure of a hydrophobic portion, hydrophobicity or coated-film strength of an image portion is not degraded by dampening water permeating into an image recording layer exposed portion (image portion) and ink receptivity or printing durability of the image recording layer can be maintained satisfactorily.
The amount of the low-molecular weight hydrophilic compounds to be added to the image recording layer is preferably in a range of 0.5% to 20% by mass with respect to the total amount of the solid content in the image recording layer. The amount thereof is more preferably in a range of 1% to 15% by mass and still more preferably in a range of 2% to 10% by mass. When the amount thereof is in the above-described range, excellent on-press developability and printing durability can be obtained.
These compounds may be used alone or in combination of two or more kinds thereof.

(2) Oil sensitizing agent

In order to improve the impressing property, an oil sensitizing agent such as a phosphonium compound, a nitrogen-containing low-molecular weight compound, or an ammonium group-containing polymer can be used for the image recording layer. Particularly, in a case where a protective layer contains an inorganic layered compound, the above-described compounds function as a surface coating agent of the inorganic layered compound and prevent a

degradation in impressing property due to the inorganic layered compound during the printing.

The phosphonium compound, the nitrogen-containing low-molecular weight compound, and the ammonium group-containing polymer are described in paragraphs [0184] to [0190] of JP2014-104631A in detail.

The content of the oil sensitizing agent is preferably in a range of 0.01% to 30.0% by mass, more preferably in a range of 0.1% to 15.0% by mass, and still more preferably in a range of 1% to 10% by mass with respect to the total solid content of the image recording layer.

(3) Other components

The image recording layer may further contain other components such as a surfactant, a coloring agent, a printing-out agent, a polymerization inhibitor, a higher fatty acid derivative, a plasticizer, inorganic fine particles, an inorganic layered compound, a co-sensitizer, and a chain transfer agent. Specifically, the compounds and the addition amounts described in paragraphs [0114] to [0159] of JP2008-284817A, paragraphs [0023] to [0027] of JP2006-091479A, and paragraph [0060] of US2008/0311520A can be preferably used.

<Formation of image recording layer A>

The image recording layer A is formed by dispersing or dissolving each of the above-described required components in a known solvent to prepare a coating solution, coating a support with the coating solution directly or through an undercoat using a known method such as a bar coater coating method, and drying the resultant, as described in paragraphs [0142] and [0143] of JP2008-195018A. The coating amount of the image recording layer (solid content) on the support to be obtained after the coating and the drying varies depending on the applications thereof, but is preferably in a range of 0.3 to 3.0 $g/m^2$. When the coating amount thereof is in the above-described range, excellent sensitivity and excellent film-coating characteristics of the image recording layer are obtained.

(Image recording layer B)

The image recording layer B contains an infrared absorbent, a polymerization initiator, a polymerizable compound, and a particulate polymer compound. Hereinafter, the constituent components of the image recording layer B will be described.

Similarly, the infrared absorbent, the polymerization initiator, and the polymerizable compound described in the image recording layer A can be used as an infrared absorbent, a polymerization initiator, and a polymerizable compound in the image recording layer B.

<Polymer compound having particulate shape>

It is preferable that the particulate polymer compound is selected from thermoplastic polymer fine particles, thermally reactive polymer fine particles, polymer fine particles having a polymerizable group, a microcapsule encapsulating a hydrophobic compound, and a microgel (cross-linked polymer fine particle). Among these, polymer fine particles having a polymerizable group and a microgel are preferable. According to a particularly preferred embodiment, the particulate polymer compound includes at least one ethylenically unsaturated polymerizable group. Because of the presence of the particulate polymer compound, effects of improving the printing durability of an exposed portion and the on-press developability of an unexposed portion are obtained.

Preferred examples of the thermoplastic polymer fine particles include hydrophobic thermoplastic polymer fine particles described in Research Disclosure No. 33303 on January, 1992, JP1997-123387A (JP-H09-123387A), JP1997-131850A (JP-H09-131850A), JP1997-171249A (JP-H09-171249A), JP1997-171250A (JP-H09-171250A), and EP931647B.

Specific examples of a polymer constituting thermoplastic polymer fine particles include homopolymers or copolymers of monomers such as acrylate or methacrylate having structures of ethylene, styrene, vinyl chloride, methyl acrylate, ethyl acrylate, methyl methacrylate, ethyl methacrylate, vinylidene chloride, acrylonitrile, vinyl carbazole, and polyalkylene, and mixtures of these. Among these, polystyrene, styrene, a copolymer containing acrylonitrile, and polymethylmethacrylate are more preferable. The average particle diameter of the thermoplastic polymer fine particles is preferably in a range of 0.01 to 3.0 μm. The average particle diameter is calculated according to a laser light scattering method.

Examples of the thermally reactive polymer fine particles include polymer fine particles having a thermally reactive group. The thermally reactive polymer fine particles are cross-linked by a thermal reaction and have hydrophobic regions formed by a change in functional groups during the cross-linking.

As the thermally reactive group in polymer fine particles having a thermally reactive group, a functional group

that performs any reaction may be used as long as a chemical bond is formed, but a polymerizable group is preferable. Preferred examples of the polymerizable group include an ethylenically unsaturated group that performs a radical polymerization reaction (such as an acryloyl group, a methacryloyl group, a vinyl group, or an allyl group); a cationic polymerizable group (such as a vinyl group, a vinyloxy group, an epoxy group, or an oxetanyl group); an isocyanate group that performs an addition reaction or a block body thereof, an epoxy group, a vinyloxy group, and a functional group having active hydrogen atoms as the reaction partners of these (such as an amino group, a hydroxy group, or a carboxy group); a carboxy group that performs a condensation reaction and a hydroxy group or an amino group as a reaction partner thereof; and an acid anhydride that performs a ring opening addition reaction and an amino group or a hydroxy group as a reaction partner thereof.

The microcapsule is a microcapsule in which at least a part of constituent components of the image recording layer is encapsulated as described in JP2001-277740A and JP2001-277742A. Further, the constituent components of the image recording layer may be contained in a portion other than the microcapsule. Moreover, a preferred embodiment of the image recording layer containing the microcapsule is an embodiment in which hydrophobic constituent components are encapsulated by a microcapsule and hydrophilic constituent components are contained by a portion other than the microcapsule.

The microgel (cross-linked polymer fine particles) may contain a part of the constituent components of the image recording layer in at least one of the surface or the inside thereof. From the viewpoints of image forming sensitivity and printing durability, a reactive microgel having a radical polymerizable group on the surface thereof is particularly preferable.

The constituent components of the image recording layer can be made into microcapsules or microgel particles using a known method.

The average particle diameter of the particulate polymer compound is preferably in a range of 0.01 to 3.0 μm, more preferably in a range of 0.03 to 2.0 μm, and still more preferably in a range of 0.10 to 1.0 μm. When the average particle diameter thereof is in the above-described range, excellent resolution and temporal stability are obtained. The average particle diameter is calculated according to a laser light scattering method.

The content of the particulate polymer compound is preferably in a range of 5% to 90% by mass with respect to the total solid content of the image recording layer.

<Other components>

The image recording layer B can contain other components described in the above-described image recording layer A as necessary.

<Formation of image recording layer B>

The image recording layer B can be formed in the same manner as the image recording layer A described above.

(Image recording layer C)

The image recording layer C contains an infrared absorbent and thermoplastic polymer fine particles. Hereinafter, the constituent components of the image recording layer C will be described.

<Infrared absorbent>

The infrared absorbent contained in the image recording layer C is a dye or a pigment having maximum absorption at a wavelength of 760 to 1,200 nm. A dye is more preferable.

As the dye, commercially available dyes and known dyes described in the literatures (for example, "Dye Handbook" edited by The Society of Synthetic Organic Chemistry, Japan, published in 1970, "Infrared Absorbind Dyes" of "Chemical Industry", p. 45 to 51, published on May, 1986, and "Development and Market Trend of Functional Dyes in 1990's" Section 2.3 of Chapter 2 (CMC Publishing Co., Ltd., 1990)) and the patents can be used. Specific preferred examples thereof include infrared absorbing dyes such as an azo dye, a metal complex salt azo dye, a pyrazolone azo dye, an anthraquinone dye, a phthalocyanine dye, a carbonium dye, a quinone imine dye, a polymethine dye, and a cyanine dye.

Among these, infrared absorbing dyes having a water-soluble group are particularly preferable from the viewpoint of addition to the image recording layer.

Specific examples of the infrared absorbing dyes are described below, but the present invention is not limited thereto.

(IR-1)

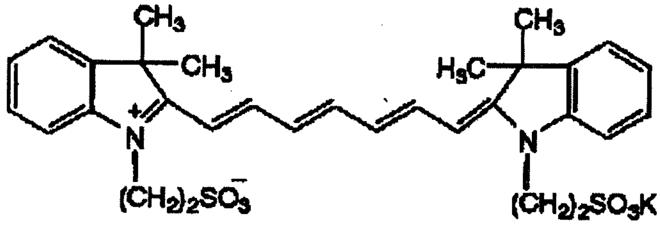

(IR-2)

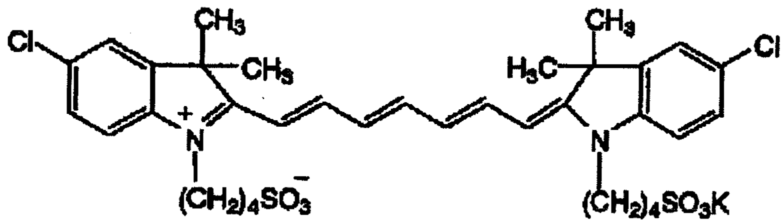

(IR-3)

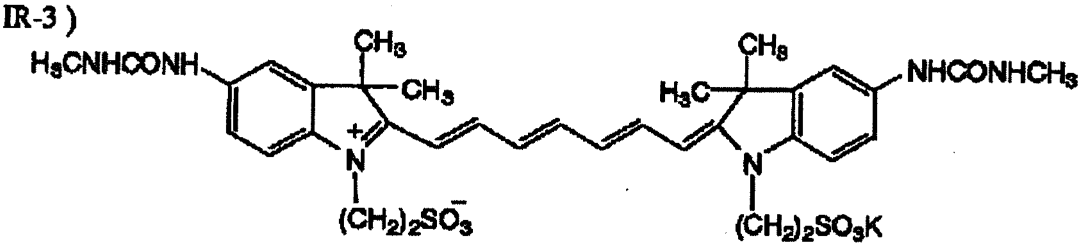

(IR-4)

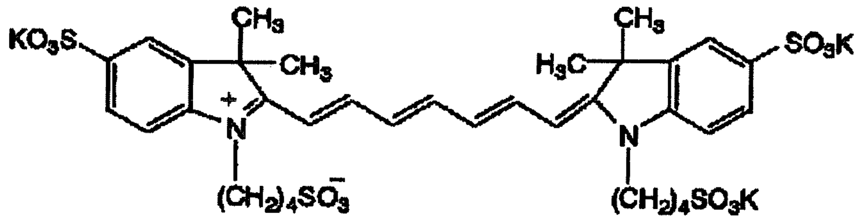

(IR-5)

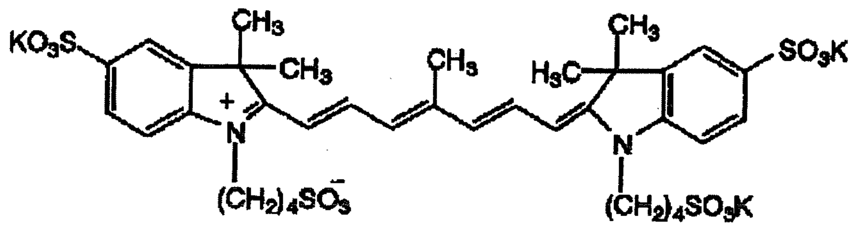

(IR-6)

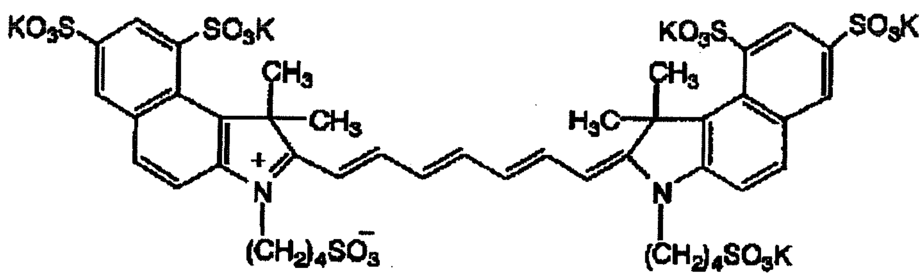

(IR-7)

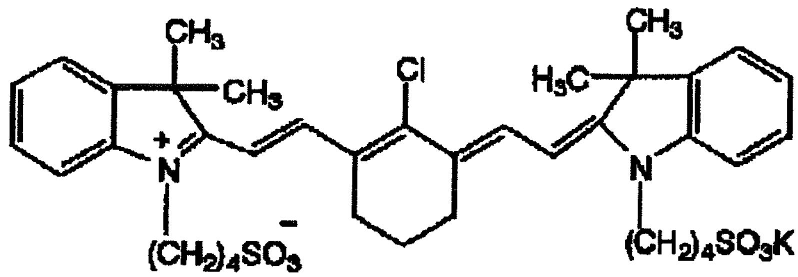

(IR-8)

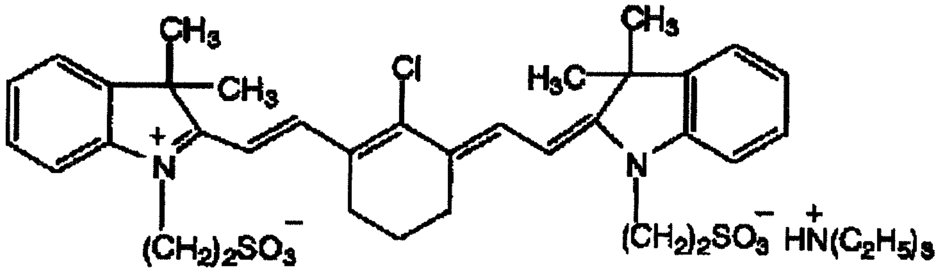

(IR-9)

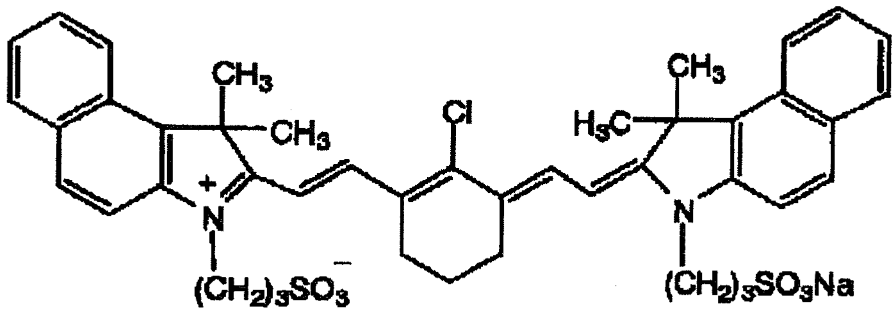

(IR-10)

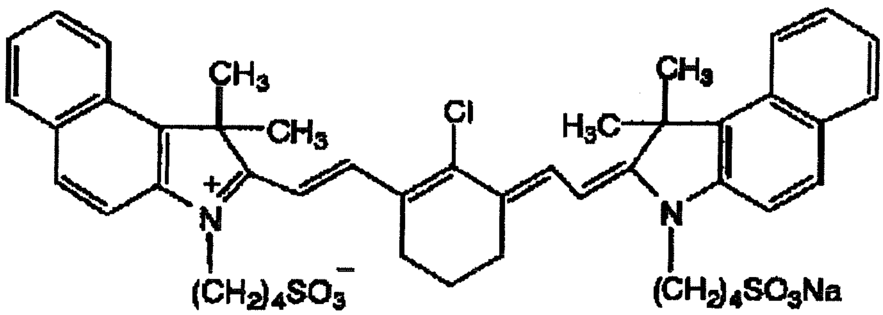

(IR-11)

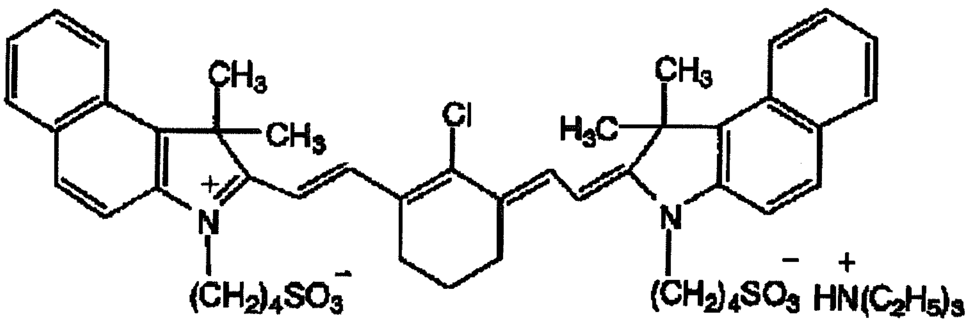

As the pigments, commercially available pigments and pigments described in Color Index (C. I.) Handbook, "Latest Pigment Handbook" (edited by Japan Pigment Technology Association, 1977), "Latest Pigment Application Technology" (CMC Publishing Co., Ltd., 1986), and "Printing Ink Technology" (CMC Publishing Co., Ltd., 1984) can be used.

The particle diameter of the pigment is preferably in a range of 0.01 to 1 μm and more preferably in a range of 0.01 to 0.5 μm. A known dispersion technique used to produce inks or toners can be used as a method of dispersing the pigment. The details are described in "Latest Pigment Application Technology" (CMC Publishing Co., Ltd., 1986).

The content of the infrared absorbent is preferably in a range of 0.1% to 30% by mass, more preferably in a range of 0.25% to 25% by mass, and particularly preferably in a range of 0.5% to 20% by mass with respect to the solid content of the image recording layer. When the content thereof is in the above-described range, excellent sensitivity is obtained without damaging the film hardness of the image recording layer.

<Thermoplastic polymer fine particles>

The glass transition temperature (Tg) of the thermoplastic polymer fine particles is preferably in a range of 60°C to 250°C. Tg of the thermoplastic polymer fine particles is more preferably in a range of 70°C to 140°C and still more preferably in a range of 80°C to 120°C.

Preferred examples of the thermoplastic polymer fine particles having a Tg of 60°C or higher include thermoplastic polymer fine particles described in Research Disclosure No. 33303 on January, 1992, JP1997-123387A (JP-H09-123387A), JP1997-131850A (JP-H09-131850A), JP1997-171249A (JP-H09-171249A), JP1997-171250A (JP-H09-171250A), and EP931647B.

Specific examples thereof include homopolymers or copolymers formed of monomers such as ethylene, styrene, vinyl chloride, methyl acrylate, ethyl acrylate, methyl methacrylate, ethyl methacrylate, vinylidene chloride, acrylonitrile, and vinyl carbazole, and mixtures of these. Among these, polystyrene and polymethylmethacrylate are preferable.

The average particle diameter of the thermoplastic polymer fine particles is preferably in a range of 0.005 to 2.0 μm from the viewpoints of the resolution and the temporal stability. This value is used as the average particle diameter in a case where two or more kinds of thermoplastic polymer fine particles are mixed with each other. The average particle diameter thereof is more preferably in a range of 0.01 to 1.5 μm and particularly preferably in a range of 0.05 μm to 1.0 μm. The polydispersity in a case where two or more kinds of thermoplastic polymer fine particles are mixed with each other is preferably 0.2 or greater. The average particle diameter and the polydispersity are calculated according to a laser light scattering method.

The thermoplastic polymer fine particles may be used in combination of two or more kinds thereof. Specifically, at least two kinds of thermoplastic polymer fine particles with different particle sizes or at least two kinds of thermoplastic polymer fine particles with different glass transition temperatures may be exemplified. When two or more kinds of thermoplastic polymer fine particles are used in combination, coated-film curing properties of an image portion are further improved and printing durability in a case where a planographic printing plate is obtained is further improved.

For example, in a case where thermoplastic polymer fine particles having the same particle size are used, voids are present between the thermoplastic polymer fine particles to some extent, the curing properties of the coated-film are not desirable in some cases even when the thermoplastic polymer fine particles are melted and solidified by image exposure. Meanwhile, in a case where thermoplastic polymer fine particles having different particle sizes are used, the void volume between the thermoplastic polymer fine particles can be decreased and thus the coated-film curing properties of the image portion after image exposure can be improved.

Further, in a case where thermoplastic polymer fine particles having the same Tg are used, the thermoplastic polymer fine particles are not sufficiently melted and solidified and, accordingly, the coated-film curing properties are not desirable in some cases when an increase in temperature of the image recording layer resulting from image exposure is insufficient. Meanwhile, in a case where thermoplastic polymer fine particles having different glass transition temperatures are used, the coated-film curing properties of the image portion can be improved when an increase in temperature of the image recording layer resulting from image exposure is insufficient.

In a case where two or more kinds of thermoplastic polymer fine particles having different glass transition temperatures are used in combination, the Tg of at least one thermoplastic polymer fine particle is preferably 60°C or higher. At this time, a difference in Tg is preferably 10°C or higher and more preferably 20°C or higher. In addition, the content of the thermoplastic polymer fine particles having a Tg of 60°C or higher is 70% by mass or greater with respect to the total amount of all thermoplastic polymer fine particles.

The thermoplastic polymer fine particles may include a cross-linking group. When thermoplastic polymer fine particles having a cross-linking group are used, the cross-linking group is thermally reacted due to heat generated by an image-exposed portion, cross-linking occurs between polymers, coated-film strength of an image portion is improved, and printing durability becomes more excellent. As the cross-linking group, a functional group, in which any reaction may occur, is not limited as long as a chemical bond is formed, and examples thereof include an ethylenically unsaturated

group that performs a polymerization reaction (such as an acryloyl group, a methacryloyl group, a vinyl group, or an allyl group); an isocyanate group that performs an addition reaction or a block body thereof, and a group having active hydrogen atoms as the reaction partners of these (such as an amino group, a hydroxy group, or a carboxyl group); an epoxy group that performs an addition reaction and an amino group, a carboxyl group or a hydroxy group as reaction partners thereof; a carboxyl group that performs a condensation reaction and a hydroxy group or an amino group; and an acid anhydride that performs a ring opening addition reaction and an amino group or a hydroxy group.

Specific examples of the thermoplastic polymer fine particles having a cross-linking group include thermoplastic polymer fine particles having cross-linking groups such as an acryloyl group, a methacryloyl group, a vinyl group, an allyl group, an epoxy group, an amino group, a hydroxy group, a carboxyl group, an isocyanate group, an acid anhydride, and a group protecting these. These cross-linking groups may be introduced to polymers at the time of polymerization of fine particle polymers or may be introduced using a polymer reaction after polymerization of fine particle polymers.

In a case where a cross-linking group is introduced to a polymer at the time of polymerization of polymer fine particles, it is preferable that a monomer having a cross-linking group may be subjected to an emulsion polymerization or suspension polymerization. Specific examples of the monomer having a cross-linking group include allyl methacrylate, allyl acrylate, vinyl methacrylate, vinyl acrylate, glycidyl methacrylate, glycidyl acrylate, 2-isocyanate ethyl methacrylate or block isocyanate resulting from alcohol thereof, 2-isocyanate ethyl acrylate or block isocyanate resulting from alcohol thereof, 2-aminoethyl methacrylate, 2-aminoethyl acrylate, 2-hydroxyethyl methacrylate, 2-hydroxyethyl acrylate, acrylic acid, methacrylic acid, maleic anhydride, bifunctional acrylate, and bifunctional methacrylate.

Examples of the polymer reaction used in a case where a cross-linking group is introduced after polymerization of polymer fine particles include polymer reactions described in WO96/34316A.

Polymer fine particles may react with each other through a cross-linking group or the thermoplastic polymer fine particles may react with a polymer compound or a low-molecular weight compound added to the image recording layer.

The content of the thermoplastic polymer fine particles is preferably in a range of 50% to 95% by mass, more preferably in a range of 60% to 90% by mass, and particularly preferably in a range of 70% to 85% by mass with respect to the solid content of the image recording layer.

<Other components>

The image recording layer C may contain other components as necessary.

<Surfactant having polyoxyalkylene group or hydroxy group>

As a surfactant having a polyoxyalkylene group (hereinafter, also referred to as a POA group) or a hydroxy group, a surfactant having a POA group or a hydroxy group may be suitably used, but an anionic surfactant or a non-ionic surfactant is preferable. Among anionic surfactants or non-ionic surfactants having a POA group or a hydroxy group, anionic surfactants or non-ionic surfactants having a POA group are preferable.

As the POA group, a polyoxyethylene group, a polyoxypropylene group, or a polyoxybutylene group is preferable and a polyoxyethylene group is particularly preferable.

The average degree of polymerization of an oxyalkylene group is practically in a range of 2 to 50 and preferably in a range of 2 to 20.

The number of hydroxy groups is practically 1 to 10 and preferably in a range of 2 to 8. Here, the number of terminal hydroxy groups in the oxyalkylene group is not included in the number of hydroxy groups.

(Anionic surfactant having POA group or hydroxy group)

The anionic surfactant having a POA group is not particularly limited, and examples thereof include polyoxyalkylene alkyl ether carboxylates, polyoxyalkylene alkyl sulfosuccinates, polyoxyalkylene alkyl ether sulfuric acid ester salts, alkyl phenoxy polyoxyalkylene propyl sulfonates, polyoxyalkylene alkyl sulfophenyl ethers, polyoxyalkylene aryl ether sulfuric acid ester salts, polyoxyalkylene polycyclic phenylether sulfuric acid ester salts, polyoxyalkylene styryl phenyl ether sulfuric acid ester salts, polyoxyalkylene alkyl ether phosphoric acid ester salts, polyoxyalkylene alkyl phenyl ether phosphoric acid ester salts, and polyoxyalkylene perfluoroalkyl ether phosphoric acid ester salts.

The anionic surfactant having a hydroxy group is not particularly limited, and examples thereof include hydroxy carboxylates, hydroxy alkyl ether carboxylates, hydroxy alkane sulfonates, fatty acid monoglyceride sulfuric acid ester salts, and fatty acid monoglyceride acid ester salts.

The content of the surfactant having a POA group or a hydroxy group is preferably in a range of 0.05% to 15% by mass and more preferably in a range of 0.1% to 10% by mass with respect to the solid content of the image recording layer.

Hereinafter, specific examples of the surfactant having a POA group or a hydroxy group will be described, but

the present invention is not limited thereto. A surfactant A-12 described below is a trade name of Zonyl FSP and available from Dupont. Further, a surfactant N-11 described below is a trade name of Zonyl FSO 100 and available from Dupont.

A-1

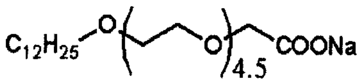

A-2

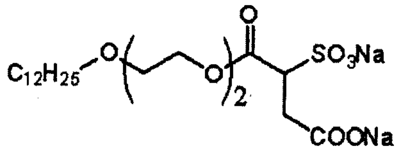

A-3

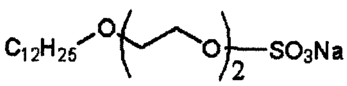

A-4

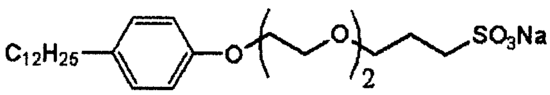

A-5

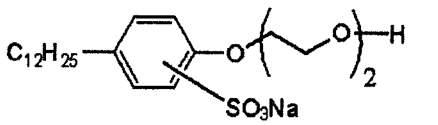

A-6

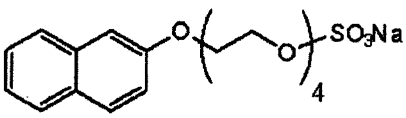

A-7

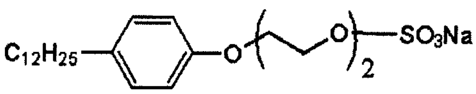

A-8

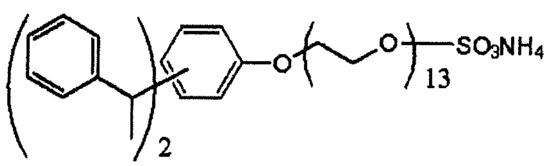

A-9

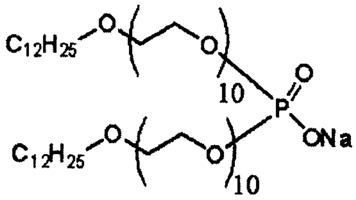

A-10

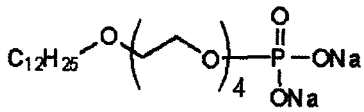

A-11

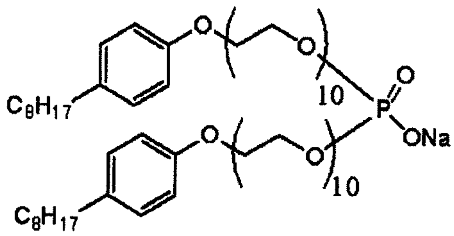

A-12

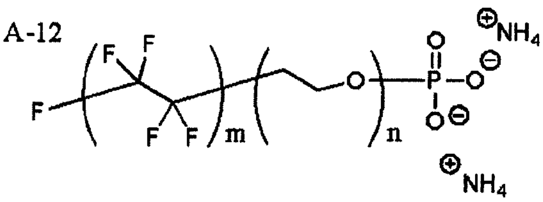

A-13

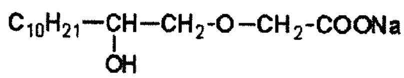

A-14

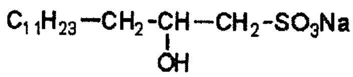

A-15

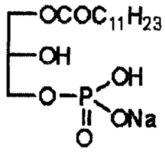

N-1 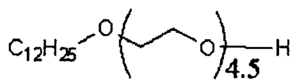

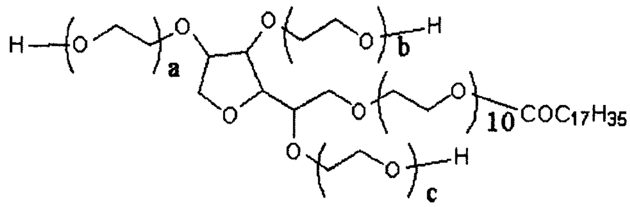

N-2 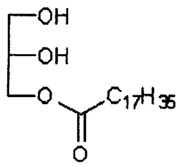

a+b+c=20

N-8

N-3 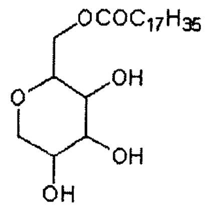

N-9 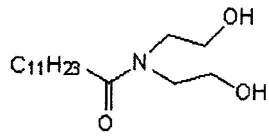

N-10 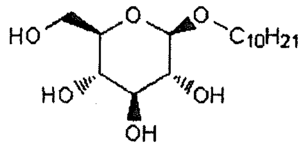

N-4 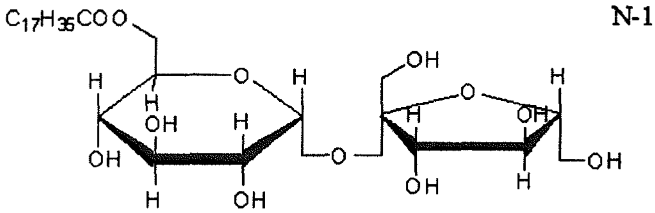

N-11 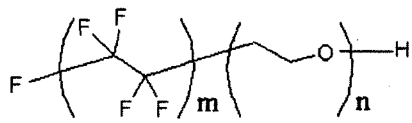

N-5 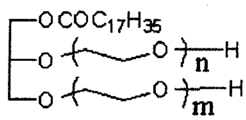 m+n=5

N-6 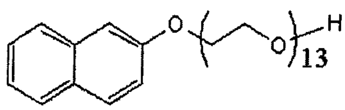

N-7 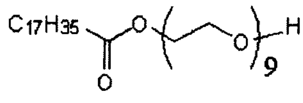

For the purpose of ensuring coating uniformity of the image recording layer, the image recording layer may contain an anionic surfactant that does not have a polyoxyalkylene group or a hydroxy group.

The anion surfactant is not particularly limited as long as the above-described purpose is achieved. Among the examples of the anionic surfactants, alkyl benzene sulfonic acid or a salt thereof, alkyl naphthalene sulfonic acid or a salt thereof, (di)alkyl diphenyl ether (di)sulfonic acid or a salt thereof, or alkyl sulfuric acid ester salt is preferable.

The addition amount of the anionic surfactant that does not have a polyoxyalkylene group or a hydroxy group is preferably in a range of 1% to 50% by mass and more preferably in a range of 1% to 30% by mass with respect to the surfactant which has a polyoxyalkylene group or a hydroxy group.

Hereinafter, specific examples of the anionic surfactant that does not have a polyoxyalkylene group or a hydroxy group will be described, but the present invention is not limited thereto.

AA-1 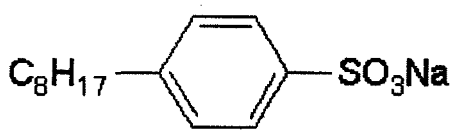

AA-2 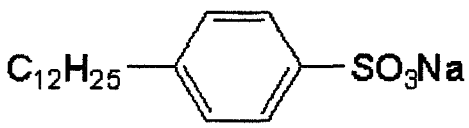

AA-3 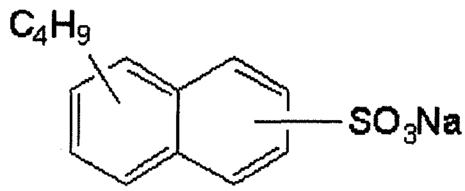

AA-4 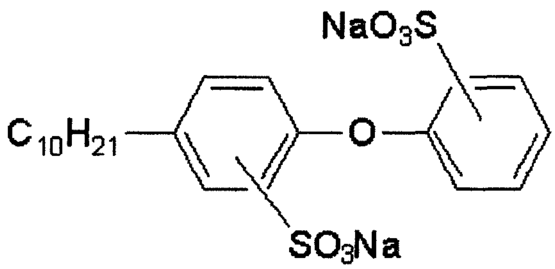

AA-5 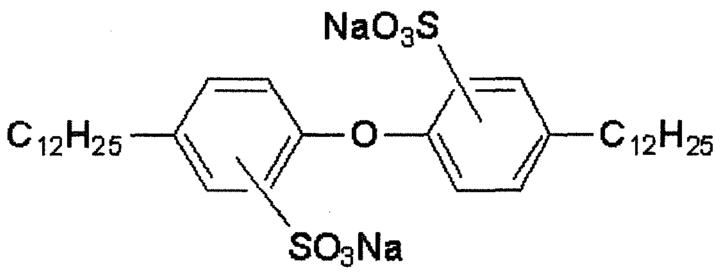

AA-6 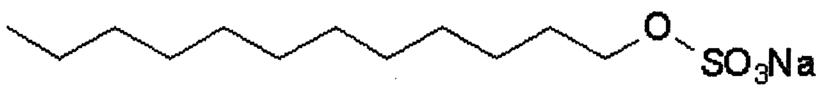

Further, for the purpose of coating uniformity of the image recording layer, a non-ionic surfactant that does not have a polyoxyalkylene group or a hydroxy group or a fluorine surfactant may be used. For example, fluorine surfactants described in JP1987-170950A (JP-S62-170950A) are preferably used.

The image recording layer may contain a hydrophilic resin. Preferred examples of the hydrophilic resin include resins having hydrophilic groups such as a hydroxy group, a hydroxyethyl group, a hydroxypropyl group, an amino group, an aminoethyl group, an aminopropyl group, a carboxyl group, a carboxylate group, a sulfo group, a sulfonate group, and a phosphoric acid group.

Specific examples of the hydrophilic resin include gum Arabic, casein, gelatin, a starch derivative, carboxy methyl cellulose and sodium salt thereof, cellulose acetate, sodium alginate, vinyl acetate-maleic acid copolymers, styrene-maleic acid copolymers, polyacrylic acids and salts of these, polymethacrylic acids and salts of these, a homopolymer and a copolymer of hydroxy ethyl methacrylate, a homopolymer and a copolymer of hydroxy ethyl acrylate, a homopolymer and a copolymer of hydroxy propyl methacrylate, a homopolymer and a copolymer of hydroxy propyl acrylate, a homopolymer and a copolymer of hydroxy butyl methacrylate, a homopolymer and a copolymer of hydroxy

butyl acrylate, polyethylene glycols, hydroxy propylene polymers, polyvinyl alcohols, hydrolyzed polyvinyl acetate having a degree of hydrolysis of at least 60% and preferably at least 80%, polyvinyl formal, polyvinyl butyral, polyvinyl pyrrolidone, a homopolymer and a copolymer of acrylamide, a homopolymer and a copolymer of methacrylamide, and a homopolymer and a copolymer of N-methylol acrylamide.

The weight-average molecular weight of the hydrophilic resin is preferably 2,000 or greater from the viewpoints of obtaining sufficient coated-film strength or printing durability.

The content of the hydrophilic resin is preferably in a range of 0.5% to 50% by mass and more preferably in a range of 1% to 30% by mass with respect to the solid content of the image recording layer.

The image recording layer may contain inorganic fine particles. Preferred examples of the inorganic fine particles include silica, alumina, magnesium oxide, titanium oxide, magnesium carbonate, calcium alginate, and a mixture of these. The inorganic fine particles can be used for the purpose of improving coated-film strength.

The average particle diameter of the inorganic fine particles is preferably in a range of 5 nm to 10 μm and more preferably in a range of 10 nm to 1 μm. When the average particle diameter thereof is in the above described range, the thermoplastic polymer fine particles are stably dispersed, the film hardness of the image recording layer is sufficiently held, and a non-image portion with excellent hydrophilicity in which printing stain is unlikely to occur can be formed.

The inorganic fine particles are available as commercial products such as a colloidal silica dispersion and the like.

The content of the inorganic fine particles is preferably in a range of 1.0 % to 70% by mass and more preferably in a range of 5.0% to 50% by mass with respect to the solid content of the image recording layer.

The image recording layer may contain a plasticizer in order to provide flexibility for a coated film. Examples of the plasticizer include polyethylene glycol, tributyl citrate, diethyl phthalate, dibutyl phthalate, dihexyl phthalate, dioctyl phthalate, tricresyl phosphate, tributyl phosphate, trioctyl phosphate, and tetrahydrofurfuryl oleate.

The content of the plasticizer is preferably in a range of 0.1% to 50% by mass and more preferably in a range of 1% to 30% by mass with respect to the solid content of the image recording layer.

In a case where polymer fine particles having a thermally reactive functional group (cross-linking group) are used for the image recording layer, a compound that starts or promotes a reaction of the thermally reactive functional group (cross-linking group) can be added to the image recording layer as necessary. As the compound that starts or promotes a reaction of the thermally reactive functional group, a compound that generates a radical or a cation by heating may be exemplified. Examples of the compound include a lophine dimer, a trihalomethyl compound, a peroxide, an azo compound, onium salts including diazonium salts and diphenyl iodonium salts, acyl phosphine, and imide sulfonate. The amount of the compound to be added to the image recording layer is preferably in a range of 1% to 20% by mass and more preferably in a range of 1% to 10% by mass with respect to the solid content of the image recording layer. When the amount thereof is in the above-described range, on-press developability is not degraded and excellent effects for starting or promoting a reaction are obtained.

<Formation of image recording layer C>

The image recording layer C is formed by dissolving or dispersing each of the above-described required components in a suitable solvent to prepare a coating solution, coating a support with the coating solution directly or through an undercoat. As the solvent, water or a mixed solvent of water and an organic solvent is used, and a mixed solvent of water and an organic solvent is preferable from the viewpoint of the excellent surface state after coating. Since the amount of the organic solvent varies depending on the type of organic solvent, the amount thereof cannot be specified unconditionally, but the amount of the organic solvent in the mixed solvent is preferably in a range of 5% to 50% by volume. Here, it is necessary that the amount of the organic solvent to be used is set such that the thermoplastic polymer fine particles are not aggregated. The concentration of solid contents of the image recording layer coating solution is preferably in a range of 1% to 50% by mass.

As the organic solvent used as a solvent of the coating solution, a water-soluble organic solvent is preferable. Specific examples thereof include an alcohol solvent such as methanol, ethanol, propanol, isopropanol, or 1-methoxy-2-propanol, a ketone solvent such as acetone or methyl ethyl ketone, a glycol ether solvent such as ethylene glycol dimethyl ether, γ-butyrolactone, N,N-dimethylformamide, N,N-dimethylacetamide, tetrahydrofuran, and dimethylsulfoxide. Particularly, an organic solvent having a boiling point of 120°C or lower and a solubility (amount of a solvent to be dissolved in 100 g of water) of 10 g or greater in water is preferable and an organic solvent having a solubility of 20 g or greater is more preferable.

As a coating method of the image recording layer coating solution, various methods can be used. Examples of the methods include a bar coater coating method, a rotary coating method, a spray coating method, a curtain coating method, a dip coating method, an air knife coating method, a blade coating method, and a roll coating method. The coating amount (solid content) of the image recording layer on the support obtained after the coating and the drying varies depending on the purpose thereof, but is preferably in a range of 0.5 to 5.0 g/$m^2$ and more preferably in a range of 0.5 to 2.0 g/$m^2$.

The image recording layer of the planographic printing plate precursor according to the present invention may be an image recording layer whose non-image portion is removed by a developer. Such an image recording layer includes image recording layers of many planographic printing plate precursors known as a so-called development treatment type planographic printing plate precursor.

According to one embodiment of the image recording layer to be removed by a developer, the image recording layer may be a negative type image recording layer containing a sensitizing dye, a polymerization initiator, a polymerizable compound, and a binder polymer. Such a negative type image recording layer is described as a "recording layer" in paragraphs [0057] to [0154] of JP2008-15503A.

According to one embodiment of the image recording layer to be removed by a developer, the image recording layer is a positive type image recording layer containing a water-insoluble and alkali-soluble resin and an infrared absorbent. Such a positive type image recording layer is described as a "recording layer" in paragraphs [0055] to [0132] of JP2007-148040A.

Hereinafter, other constituent elements of the planographic printing plate precursor will be described.

[Undercoat layer]

The planographic printing plate precursor may be provided with an undercoat between the image recording layer and the support as necessary. Since bonding of the support to the image recording layer becomes stronger in an exposed portion and the support is easily separated from the image recording layer in an unexposed portion, the undercoat contributes to improvement of the on-press developability without degrading the printing durability. Further, in a case of infrared layer exposure, the undercoat functions as a heat insulating layer so that a degradation in sensitivity due to heat, generated by exposure, being diffused in the support is prevented.

Examples of eth compound used for the undercoat include a silane coupling agent having an ethylenic double bond reaction group, which can be added and polymerized, described in JP1998-282679A (JP-H10-282679A); and a phosphorous compound having an ethylenic double bond reaction group described in JP1990-304441A (JP-H02-304441A). Preferred examples thereof include polymer compounds having an adsorptive group which can be adsorbed to the surface of the support, a hydrophilic group, and a cross-linking group, as described in JP2005-125749A and JP2006-188038A. As such a polymer compound, a copolymer of a monomer having an adsorptive group, a monomer having a hydrophilic group, and a monomer having a cross-linking group is preferable. Specific examples thereof include a copolymer of a monomer having an adsorptive group such as a phenolic hydroxy group, a carboxy group, $-PO3H_2$, $-OPO_3H_2$, $-CONHSO_2-$, $-SO_2NHSO_2-$, or $-COCH_2COCH_3$, a monomer having a hydrophilic group such as a sulfo group, and a monomer having a polymerizable cross-linking group such as a methacryl group or an allyl group. The polymer compound may include a cross-linking group introduced by forming salts between a polar substituent of the polymer compound and a compound that includes a substituent having the opposite charge and an ethylenic unsaturated bond. Further, monomers other than the monomers described above, preferably hydrophilic monomers may be further copolymerized.

The content of the unsaturated double bond in the polymer compound for an undercoat is preferably in a range of 0.1 to 10.0 mmol and more preferably in a range of 2.0 to 5.5 mmol with respect to 1 g of the polymer compound.

The weight-average molecular weight of the polymer compound for an undercoat is preferably 5,000 or greater and more preferably in a range of 10,000 to 300,000.

For the purpose of preventing stain over time, the undercoat may contain a chelating agent, a secondary or tertiary amine, a polymerization inhibitor, an amino group, a compound that includes an amino group or a functional group having polymerization inhibiting ability and a group interacting with the surface of an aluminum support, and the like (for example, 1,4-diazabicyclo[2,2,2]octane (DABCO), 2,3,5,6-tetrahydroxy-p-quinone, chloranil, sulfophthalic acid, hydroxyethyl ethylene diamine triacetic acid, dihydroxyethyl ethylene diamine diacetic acid, or hydroxyethyl imino diacetic acid) in addition to the compounds for an undercoat described above.

The undercoat is applied according to a known method. The coating amount (solid content) of the undercoat is preferably in a range of 0.1 to 100 $mg/m^2$ and more preferably in a range of 1 to 30 $mg/m^2$.

[Support]

A known support is used as the support of the planographic printing plate precursor. Among examples of the known support, an aluminum plate subjected to a roughening treatment and an anodizing treatment using a known method is preferable.

The aluminum plate can be subjected to a treatment appropriately selected from an expansion treatment or a sealing treatment of micropores of an anodized film described in JP2001-253181A or JP2001-322365A or a surface hydrophilization treatment using alkali metal silicate described in US2714066A, US3181461A, US3280734A, and US3902734A or polyvinyl phosphonic acid described in US3276868A, US4153461A, and US4689272A as necessary.

The center line average roughness of the support is preferably in a range of 0.10 to 1.2 μm.

[Protective layer]

A protective layer may be provided on the image recording layer of the precursor as necessary. The protective layer has a function of suppressing a reaction of inhibiting image formation through oxygen blocking, a function of preventing generation of damage to the image recording layer, and a function of preventing ablation at the time of high illuminance laser exposure.

As the protective layer having such functions, a protective layer described in paragraphs [0202] to [0204] of JP2014-104631A can be used.

The protective layer is applied according to a known method. The coating amount of the protective layer after the drying is preferably in a range of 0.01 to 10 $g/m^2$, more preferably in a range of 0.02 to 3 $g/m^2$, and particularly preferably in a range of 0.02 to 1 $g/m^2$.

The planographic printing plate precursor can be produced by applying a coating solution of each configuration layer according to a typical method, performing drying, and forming each configuration layer. The coating solution can be applied according to a die coating method, a dip coating method, an air knife coating method, a curtain coating method, a roller coating method, a wire bar coating method, a gravure coating method, or a slide coating method.

Hereinafter, a blank plate precursor for printing which is another preferred embodiment of the printing plate precursor will be described.

The blank plate precursor for printing is a precursor for preparing a blank plate for printing by performing the same plate-making step (here, image exposure is not performed) as that for the planographic printing plate precursor and basically does not have photosensitivity. As is well-known in the printing industry, the blank plate for printing is used by being attached to a plate cylinder in a case where it is necessary to print a part of the paper surface with two colors or one color in color newspaper printing (multicolor printing).

[Blank plate precursor for printing]

The blank plate precursor for printing according to the present invention includes a non-photosensitive layer on the support. The non-photosensitive layer in the blank plate precursor for printing corresponds to the layer containing a polymer in the printing plate precursor. The blank plate precursor for printing may include an undercoat layer between the support and the non-photosensitive layer and a hydrophilic layer on the non-photosensitive layer as necessary.

According to one preferred embodiment, the non-photosensitive layer is a non-photosensitive layer to be removed by at least one of acidic to alkaline dampening water or printing ink on a printing press.

It is preferable that the non-photosensitive layer in the blank plate precursor for printing contains a water-soluble binder polymer or a water-insoluble and alkali-soluble binder polymer (hereinafter, also referred to as a "binder polymer"). Further, the non-photosensitive layer may contain a colorant having an absorption maximum of 350 to 550 nm and a low-molecular-weight acidic compound.

The binder contained in the non-photosensitive layer of the blank plate precursor for printing is described in, for example, paragraphs [0069] to [0074] of JP2011-218778A.

The non-photosensitive layer of the blank plate precursor for printing and the method of forming the same are described in, for example, paragraphs [0021] to [0054] of JP2011-218778A.

The hydrophilic layer of the blank plate precursor for printing contains a binder.

The hydrophilic layer can be formed by coating the non-photosensitive layer with a hydrophilic layer coating solution prepared by mixing a binder and various additives such as a colorant, a water-soluble plasticizer, and a surfactant to be added depending on the purpose thereof and stirring the solution according to a method described in, for example, US3458311A or JP1980-49729A (JP-S55-49729A). The coating amount of the hydrophilic layer is preferably in a range of 0.2 to 5.0 $g/m^2$ and more preferably in a range of 0.3 to 3.0 $g/m^2$.

The binder contained in the hydrophilic layer of the blank plate precursor for printing is described in, for example, paragraphs [0069] to [0074] of JP2011-218778A.

The plate-making of the printing plate precursor according to the present invention will be described below. The plate-making of the printing plate precursor according to the present invention basically includes an image exposure step and a development treatment step. In the printing plate precursor according to the present invention, the development treatment step is performed without performing the image exposure step in a case of the blank plate precursor for printing.

[Image exposure step]

The image exposure of the planographic printing plate precursor can be performed in conformity with an image exposure operation for a typical planographic printing plate precursor.

The image exposure is performed by laser exposure through a transparent original picture having a line image, a halftone image, and the like or by laser beam scanning using digital data. The wavelength of a light source is preferably in a range of 700 to 1,400 nm. As the light source having a wavelength of 700 to 1,400 nm, a solid-state laser or a semiconductor laser that radiates infrared rays is preferable. The output of the infrared laser is preferably 100 mW or greater, the exposure time per one pixel is preferably less than 20 microseconds, and the irradiation energy quantity is preferably in a range of 10 to 300 mJ/$cm^2$. For the purpose of reducing the exposure time, it is preferable to use a multi-beam laser device. The exposure mechanism may be any of an internal drum system, an external drum system, and a flat bed system. The image exposure can be performed using a plate setter according to a usual method.

[Development treatment step]

The development step can be performed using a typical method. In a case of on-press development, a printing ink receiving portion having a lipophilic surface is formed by the image recording layer cured by light exposure in the exposed portion of the image recording layer in a case where dampening water and printing ink are supplied to the image-exposed planographic printing plate precursor on a printing press. Meanwhile, in an unexposed portion, a non-cured image recording layer is dissolved or dispersed by supplied dampening water and/or printing ink and then removed, a hydrophilic surface is exposed to the portion. As the result, dampening water is exposed and adheres to the hydrophilic surface, the printing ink is impressed on the image recording layer of the exposed region, and then the printing is started.

Here, either of dampening water or printing ink may be initially supplied to the surface of the planographic printing plate precursor, but it is preferable that dampening water is initially supplied thereto by infiltrating dampening water so that the on-press developability is promoted.

The development treatment using a developer can be performed by a conventional method. The development treatment of a development treatment type negative type planographic printing plate precursor is described in, for example, paragraphs [0197] to [0220] of JP2008-15503A. The development treatment of the development treatment type positive type planographic printing plate precursor is described in, for example, paragraphs [0157] to [0160] of JP2007-148040A.

[Printing plate precursor laminate and printing plate laminate]

A printing plate precursor laminate according to the present invention is a laminate formed by directly laminating a plurality (typically, 2 to 500) of printing plate precursors of the present invention without interposing interleaving paper between precursors.

The printing plate precursor laminate according to the present invention is excellent in all properties of resistance to mat dropping, adhesiveness, resistance to scratches, and resistance to scars because of the back coat layer having a specific configuration included in the printing plate precursor according to the present invention, and dislocation in stacking precursors does not occur.

A printing plate precursor according to the present invention is a laminate formed by directly laminating a plurality of planographic printing plates or blank plates for printing without interposing interleaving paper between plates. Such a laminate is formed by laminating a plurality of planographic printing plates or blank plates for printing and placing the laminate in an appropriate place in a case where there is a gap in time for about several hours to several days after the plate-making to initiation of printing.

The printing plate laminate according to the present invention is excellent in all properties of resistance to mat dropping, adhesiveness, resistance to scratches, and resistance to scars because of the back coat layer having a specific configuration included in the printing plate precursor according to the present invention, and dislocation in stacking precursors does not occur.

Examples

Hereinafter, the present invention will be described in detail with reference to examples, but the present invention is not limited thereto. Further, in a polymer compound, the molecular weight indicates the weight-average molecular mass (Mw) and the proportion of repeating units indicates mole percentage unless otherwise specified. Further, the mass average molecular weight (Mw) is a value in terms of polystyrene obtained by performing measurement using gel permeation chromatography (GPC).

[Examples 101 to 114 and Comparative Examples 101 to 107]

[Preparation of planographic printing plate precursor 101]

<Preparation of support 1>

An aluminum alloy plate having a thickness of 0.3 mm and having a composition listed in Table A was subjected to the following treatments (a) to (m), whereby a support 1 was produced. Moreover, during all treatment steps, a washing treatment was performed, and liquid cutting was performed using a nip roller after the washing treatment.

[Table 1]

Table A

| Composition (% by mass) | | | | | | | |
|---|---|---|---|---|---|---|---|
| Si | Fe | Cu | Mn | Mg | Zn | Ti | Al |
| 0.085 | 0.303 | 0.037 | 0 | 0 | 0 | 0.018 | Remainder |

(a) Mechanical roughening treatment (brush grain method)

While supplying a suspension of pumice (specific gravity of 1.1 g/cm$^3$) to the surface of an aluminum plate as a polishing slurry liquid, a mechanical roughening treatment was performed using rotating bundle bristle brushes.

The mechanical roughening treatment is performed under conditions in which the median diameter of a polishing material pumice was 30 μm, the number of the bundle bristle brushes was four, and the rotation speed of the bundle bristle brushes was set to 250 rpm. The material of the bundle bristle brushes was nylon 6.10, the diameter of the brush bristles was 0.3 mm, and the bristle length was 50 mm. The bundle bristle brushes were produced by implanting bristles densely into the holes in a stainless steel cylinder having a diameter of φ300 mm. The distance between two support rollers (φ200 mm) of the lower portion of the bundle bristle brush was 300 mm. The bundle bristle brushes were pressed until the load of a driving motor for rotating the brushes became 10 kW plus with respect to the load before the bundle bristle brushes were pressed against the aluminum plate. The rotation direction of the bundle bristle brushes was the same as the moving direction of the aluminum plate.

(b) Alkali etching treatment

The aluminum plate was subjected to an etching treatment by spraying a caustic soda aqueous solution in which the concentration of caustic soda was 26% by mass and the concentration of aluminum ions was 6.5% by mass using a spray tube at a temperature of 70°C. Thereafter, washing with water by spraying was performed. The amount of aluminum dissolved was 10 g/m$^2$.

(c) Desmutting treatment in acidic aqueous solution

Next, a desmutting treatment was performed in a nitric acid aqueous solution. As the nitric acid aqueous solution used in the desmutting treatment, a nitric acid electrolyte used in electrochemical roughening of the subsequent step was used. The temperature was 35°C. The desmutting treatment was performed for 3 seconds by spraying the desmutting liquid using a spray.

(d) Electrochemical roughening treatment

An electrochemical roughening treatment was continuously performed using an AC voltage of 60 Hz. An electrolyte which had been adjusted to have a concentration of aluminum ions of 4.5 g/L by adding aluminum nitrate to a nitric acid aqueous solution having a concentration of 10.4 g/L at a temperature of 35°C was used. Using a trapezoidal rectangular waveform AC having a time tp, until the current value reached a peak from zero, of 0.8 msec and the duty ratio of 1:1 as the AC power supply waveform, the electrochemical roughening treatment was performed using a carbon electrode as a counter electrode. As an auxiliary anode, ferrite was used. The current density was 30 A/dm$^2$ as the peak current value, and 5% of the current from the power source was separately flowed to the auxiliary anode. The electric

quantity was 185 C/dm$^2$ as the sum total of electric quantity at the time of anodization of the aluminum plate. Thereafter, washing with water by spraying was performed.

(e) Alkali etching treatment

The aluminum plate was subjected to an etching treatment by spraying a caustic soda aqueous solution in which the concentration of caustic soda was 5% by mass and the concentration of aluminum ions was 0.5% by mass using a spray tube at a temperature of 50°C. Thereafter, washing with water by spraying was performed. The amount of aluminum dissolved was 0.5 g/m$^2$.

(f) Desmutting treatment in acidic aqueous solution

Next, a desmutting treatment was performed in a sulfuric acid aqueous solution. As the sulfuric acid aqueous solution used in the desmutting treatment, a solution in which the concentration of sulfuric acid was 170 g/L and the concentration of aluminum ions was 5 g/L was used. The temperature was 60°C. The desmutting treatment was performed for 3 seconds by spraying the desmutting liquid using a spray.

(g) Electrochemical roughening treatment

An electrochemical roughening treatment was continuously performed using an AC voltage of hydrochloric acid electrolysis 60 Hz. An electrolyte which had been adjusted to have a concentration of aluminum ions of 4.5 g/L by adding aluminum chloride to an aqueous solution having a concentration hydrochloric acid of 6.2 g/L at a liquid temperature of 35°C was used. Using a trapezoidal rectangular waveform AC having a time tp, until the current value reached a peak from zero, of 0.8 msec and the duty ratio of 1:1, the electrochemical roughening treatment was performed using a carbon electrode as a counter electrode. As an auxiliary anode, ferrite was used. As an electrolytic cell, the electrolytic cell illustrated in Fig. 4 was used. The current density was 25 A/dm$^2$ as the peak current value, and the electric quantity in the hydrochloric acid electrolysis was 63 C/dm$^2$ as the sum total of electric quantity at the time of anodization of the aluminum plate. Thereafter, washing with water by spraying was performed.

(h) Alkali etching treatment

The aluminum plate was subjected to an etching treatment by spraying a caustic soda aqueous solution in which the concentration of caustic soda was 5% by mass and the concentration of aluminum ions was 0.5% by mass using a spray tube at a temperature of 50°C. Thereafter, washing with water by spraying was performed. The amount of aluminum dissolved was 0.1 g/m$^2$.

(i) Desmutting treatment in acidic aqueous solution

Next, a desmutting treatment was performed in a sulfuric acid aqueous solution. The desmutting treatment was performed at a solution temperature of 35°C for 4 seconds using the sulfuric acid aqueous solution (aluminum ions having a concentration of 5 g/L were contained in a sulfuric acid aqueous solution having a concentration of 170 g/L) used for the anodizing treatment step. The desmutting treatment was performed for 3 seconds by spraying the desmutting liquid using a spray.

(j) First anodizing treatment

A first step of an anodizing treatment was performed with an anodizing device using DC electrolysis. An anodized film having a predetermined film thickness was formed by performing an anodizing treatment under conditions listed in Table B. An aqueous solution containing components listed in Table B was used as the electrolyte. In Tables B to D, the "component concentration" indicates the concentration (g/L) of each component described in the section of "liquid component".

[Table 2]

Table B

| First anodizing treatment | | | | | | |
|---|---|---|---|---|---|---|
| Liquid type | Liquid component | Component concentration (g/L) | Temperature (°C) | Current density (A/$dm^2$) | Time (s) | Film thickness (nm) |
| Sulfuric acid | $H_2SO_4$/Al | 170/5 | 55 | 90 | 0.40 | 110 |

(k) Second anodizing treatment

A second step of an anodizing treatment was performed with an anodizing device using DC electrolysis. An anodized film having a predetermined film thickness was formed by performing an anodizing treatment under conditions listed in Table C. An aqueous solution containing components listed in Table C was used as the electrolyte.

[Table 3]

Table C

| Second anodizing treatment | | | | | | |
|---|---|---|---|---|---|---|
| Liquid type | Liquid component | Component concentration (g/L) | Temperature (°C) | Current density (A/$dm^2$) | Time (s) | Film thickness (nm) |
| Sulfuric acid | $H_2SO_4$/Al | 170/5 | 54 | 15 | 13 | 900 |

(1) Third anodizing treatment

A third step of an anodizing treatment was performed with an anodizing device using DC electrolysis. An anodized film having a predetermined film thickness was formed by performing an anodizing treatment under conditions listed in Table D. An aqueous solution containing components listed in Table D was used as the electrolyte.

[Table 4]

Table D

| Third anodizing treatment | | | | | | |
|---|---|---|---|---|---|---|
| Liquid type | Liquid component | Component concentration (g/L) | Temperature (°C) | Current density (A/$dm^2$) | Time (s) | Film thickness (nm) |
| Sulfuric acid | $H_2SO_4$/Al | 170/5 | 54 | 50 | 0.4 | 100 |

(m) Hydrophilization treatment

In order to ensure hydrophilicity of a non-image portion, the non-image portion was subjected to a silicate treatment by being dipped using 2.5% by mass of a No. 3 sodium silicate aqueous solution at 50°C for 7 seconds. The adhesion amount of Si was 8.5 mg/$m^2$. Thereafter, the resultant was washed with water using a spray.

The average diameter (average diameter of surface layer) of a large-diameter hole portion on the surface of the anodized film having micropores obtained in the above-described manner, the average diameter (average diameter of bottom portion) of the large-diameter hole portion in a communication position, the average diameter (diameter of

small-diameter hole portion) of a small-diameter hole portion in the communication position, the average depth of the large-diameter hole portion and the small-diameter hole portion, the thickness (thickness of barrier layer) of the anodized film from the bottom portion of the small-diameter hole portion to the surface of the aluminum plate, and the density of the small-diameter hole portion are listed in Table E. The small-diameter hole portion includes a first small-diameter hold portion and a second small-diameter hole portion with depths different from each other and a small-diameter hole portion which is deeper than the other is referred to as the first small-diameter hole portion.

[Table 5]

Table E (part 1)

| Micropore | | | | | |
|---|---|---|---|---|---|
| Large-diameter hole portion | | | | | |
| Average diameter of surface layer | Average diameter of bottom portion | Average depth | Average depth/ | Average depth/ | Shape |
| (nm) | (nm) | (nm) | average diameter of surface layer | average diameter of bottom portion | |
| 12 | 25 | 98 | 8.2 | 3.9 | Inverted taper |

[Table 6]

Table E (part 2)

| Micropore | | | | | | | |
|---|---|---|---|---|---|---|---|
| Small-diameter hole portion | | | | | Density of micropores (pores/ $\mu m^2$) | Increase magnification of surface area | Ratio (average diameter of surface layer/ diameter of small-diameter hole portion) |
| Average diameter (nm) | Average depth (nm) | Density of communication portion (portions/$\mu m^2$) | Average thickness of barrier layer (nm) | Minimum thickness of barrier layer (nm) | | | |
| 9.8 | 888, 968 | 800 (650) | 17 | 16 | 500 | 4.0 | 1.22 |

In Table E, the average value and the minimum value are shown as the barrier layer thickness. The average value is obtained by measuring 50 thicknesses of the anodized film from the bottom portion of the first small-diameter hole portion to the surface of the aluminum plate and arithmetically averaging the values.

The average diameter of micropores (average diameter of the large-diameter hole portion and the small-diameter hole portion) is a value obtained by observing 4 sheets (N = 4) of the surfaces of the large-diameter hole portion and the surfaces of the small-diameter hole portion using FE-SEM at a magnification of 150,000, measuring the diameters of micropores (the large-diameter hole portion and the small-diameter hole portion) present in a range of 400 $\times$ 600 $nm^2$ in the obtained four sheets of images, and averaging the values. Further, in a case where the depth of the large-diameter hole portion is deep and the diameter of the small-diameter hole portion is unlikely to be measured, the upper portion of the anodized film is cut and then various kinds of diameters are acquired.

The average depth of the large-diameter hole portion is a value obtained by measuring the cross section of the support (anodized film) using FE-TEM at a magnification of 500,000, measuring 60 cases (N = 60) of distances from the surface of an arbitrary micropore to the communication position in the obtained image, and averaging the values. Further, the average depth of the small-diameter hole portion is a value obtained by observing the cross section of the

support (anodized film) using FE-SEM (at a magnification of 50,000), measuring 25 cases of depths of arbitrary micropores in the obtained image, and averaging the values.

The "density of the communication portion" indicates the density of the small-diameter hole portion of the cross section of the anodized film in the communication position. The "increase magnification of the surface area" indicates the value calculated based on the following Equation (A).

Equation (A)

$$\text{Increase magnification of surface area} = 1 + \text{pore density} \times ((\pi \times (\text{average diameter of surface layer}/2 + \text{average diameter of bottom portion}/2) \times ((\text{average diameter of bottom portion}/2 - \text{average diameter of surface layer}/2)^2 + \text{depth } A^2)^{1/2} + \pi \times (\text{average diameter of bottom portion}/2)^2 - \pi \times (\text{average diameter of surface layer}/2)^2))$$

In the column of the "average depth (nm)" of the small-diameter hole portion, the average depth of the second small-diameter hole portion is shown on the left side and the average depth of the first small-diameter hole portion is shown on the right side. In the column of the "density of communication portion" of the small-diameter hole portion in Table E, the density of the first small-diameter hole portion is shown in the parentheses together with the density of the communication portion of the small-diameter hole portion.

In addition, the average diameter of the first small-diameter hole portion positioning from the bottom portion of the second small-diameter hole portion to the bottom portion of the first small-diameter hole portion was approximately 12 nm.

<Formation of back coat layer>

(Preparation of back coat layer coating solution (1))

- Tetraethyl silicate 50 parts by mass
- Water 20 parts by mass
- Methanol 15 parts by mass
- Phosphoric acid 0.05 parts by mass

After the above-described components were mixed and stirred, heat generation was started in approximately 5 minutes. The mixture was reacted for 60 minutes, and a liquid described below was added thereto, thereby preparing a back coat coating solution (1). Further, a reaction product obtained by mixing and stirring the above-described components is noted as a metal oxide 1 in Tables F to I shown below.

- Pyrogallol-formaldehyde condensation resin (Mw: 2000) 4 parts by mass
- Dimethyl phthalate 5 parts by mass
- Fluorine-based surfactant (N-butyl perfluorooctane sulfonamide ethyl acrylate/polyoxyethylene acrylate copolymer (Mw: 20000)) 0.7 parts by mass
- Methanol silica gel (manufactured by Nissan Chemical Industries, Ltd., 30% methanol solution) 50 parts by weight
- Silica-coated acrylic resin particles 10 parts by mass
- Methanol 800 parts by mass

One surface of the support 1 was bar-coated with a back coat layer coating solution (1) having the above-described composition and dried at 100°C for 120 seconds, thereby forming a back coat layer having a thickness of 1.5 μm.

<Formation of undercoat>

The other surface of the support 1 was coated with an undercoat coating solution (1) having the following composition such that the drying coating amount was set to 20 mg/$m^2$, thereby forming an undercoat.

(Undercoat coating solution (1))

- Compound (UC-1) for undercoat (the following structure) 0.18 g
- Hydroxyethyl imino diacetic acid 0.05 g
- Surfactant (EMALEX 710, manufactured by Nihon Emulsion Co., Ltd.) 0.03 g
- Water 28.0 g

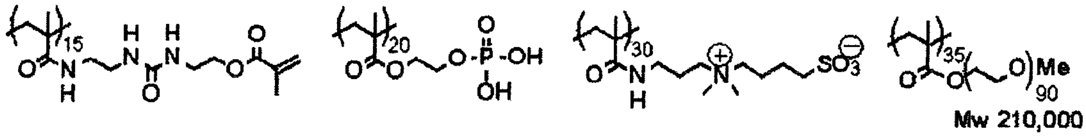

Compound (UC-1) for undercoat layer

<Formation of image recording layer>

The undercoat was bar-coated with an image recording layer coating solution (1) with the following composition and dried in an oven at 100° for 60 seconds, thereby forming an image recording layer having a drying coating amount of 1.0 g/$m^2$.

The image recording layer coating solution (1) was obtained by mixing a photosensitive solution (1) and a microgel solution (1) described below immediately before the coating and then stirring the solution.

(Image recording layer coating solution (1))

(Photosensitive solution (1))

- Binder polymer (1) (the following structure) 0.240 g
  (Mw: 55,000 and n (number of oxyethylene units): 2)
- Infrared absorbing agent (1) (the following structure) 0.020 g
- Borate compound (1) (Sodium tetraphenyl borate) 0.010 g
- Polymerization initiator (1) (the following structure) 0.162 g
- Polymerizable compound 0.192 g
  Tris (acryloyloxyethyl) isocyanurate (NK ESTER A-9300, manufactured by Shin-Nakamura Chemical Co., Ltd.)
- Anionic surfactant 1 (the following structure) 0.050 g
- Oil sensitizing agent 0.055 g
  Phosphonium compound (1) (the following structure)
- Oil sensitizing agent 0.018 g Benzyl dimethyl octyl ammonium · $PF_6$ salt
- Oil sensitizing agent 0.040 g
  Ammonium group-containing polymer (the following structure)
  (Mw: 50,000, reduction specific viscosity: 45 ml/g)
- Fluorine-based surfactant (1) (the following structure) 0.008 g
- 2-butanone 1.091 g
- 1-methoxy-2-propanol 8.609 g

(Microgel solution (1))

- Microgel (1) 2.640 g
- Distilled water 2.425 g

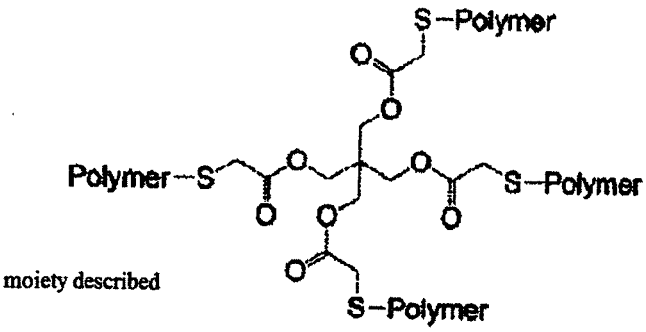

Polymer moiety described above

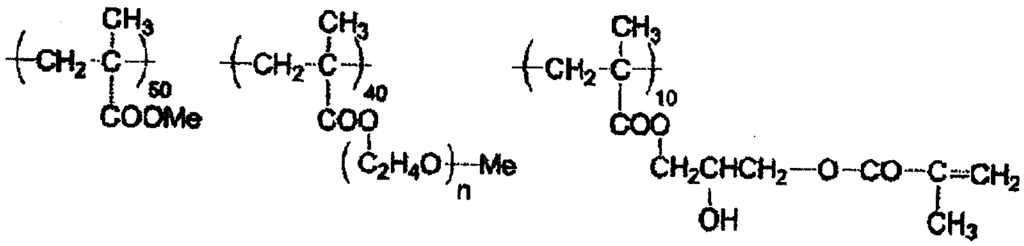

Binder polymer (1)

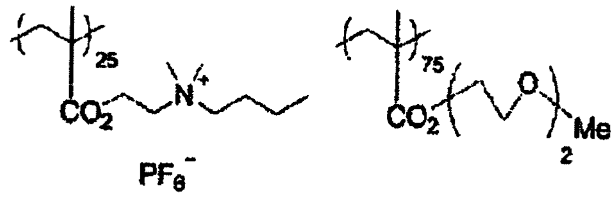

Ammonium group-containing polymer

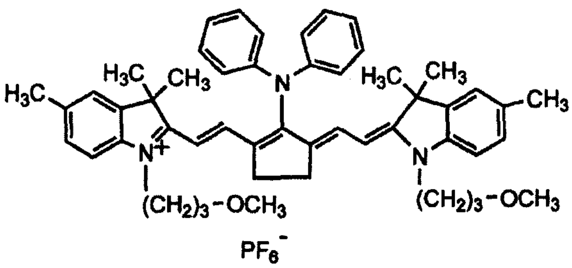

Infrared absorbent (1)

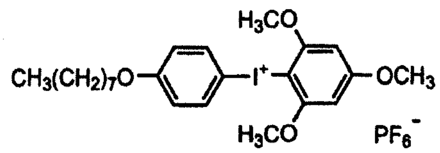

Polymerization initiator (1)

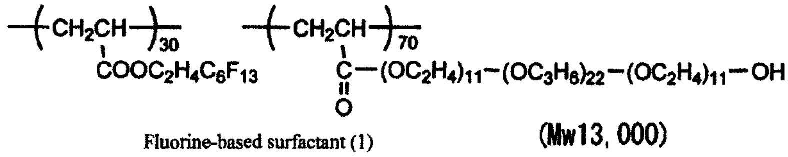

Fluorine-based surfactant (1)

(Mw13, 000)

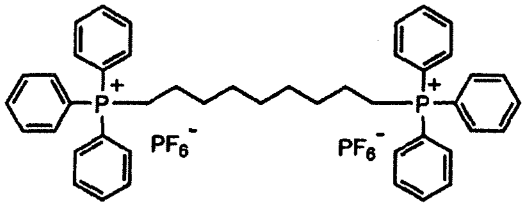

Phosphonium compound (1)

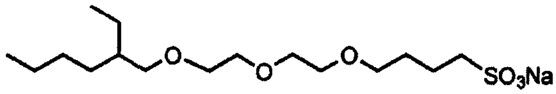

Anionic surfactant (1)

(Preparation of microgel (1))

As oil phase components, 10 g of an adduct (50% by mass of ethyl acetate solution, manufactured by Mitsui Chemical, Inc.) formed by adding 4.46 g of polyfunctional isocyanate (75 mass% ethyl acetate solution, manufactured by Mitsui Chemical, Inc.) having the following structure, trimethylolpropane (6 mol), and xylene diisocyanate (18 mol), and adding methyl one-terminal polyoxyethylene (1 mol, repetition number of oxyethylene units: 90), 3.15 g of pentaerythritol triacrylate (SR444, manufactured by Nippon Kayaku Co., Ltd.), and 0.1 g of PIONINE A-41C (manufactured by TAKEMOTO OIL & FAT Co., Ltd.) were dissolved in 17 g of ethyl acetate. As water phase components, 40 g of a 4 mass% aqueous solution of polyvinyl alcohol (PVA-205, manufactured by KURARAY CO., LTD.) was prepared. The oil phase components and the water phase components were mixed with each other and emulsified at 12,000 rpm for 10 minutes using a homogenizer. 25 g of distilled water was added to the obtained emulsion, and the resultant was stirred at room temperature for 30 minutes and stirred at 50°C for 3 hours. The microgel solution obtained in this manner was diluted with distilled water such that the concentration of solid contents was set to 15% by mass, thereby preparing a microgel (1). The average particle diameter of the microgel measured by a light scattering method was 0.2 μm.

Polyfunctional isocyanate

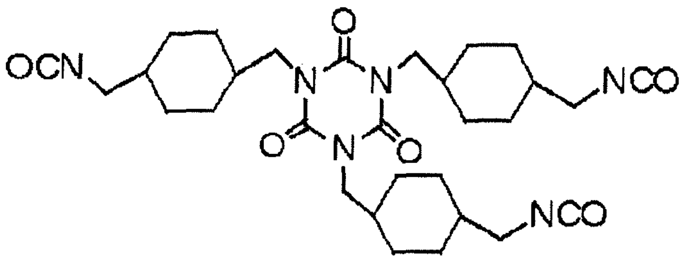

<Formation of protective layer>

The image recording layer was bar-coated with a protective layer coating solution (1) with the following composition and dried in an oven at 120° for 60 seconds to form a protective layer having a drying coating amount of 0.15 g/m$^2$, thereby preparing a planographic printing plate precursor 101.

(Protective layer coating solution (1))

- Inorganic layered compound dispersion liquid (1) (described below) 1.5 g
- Hydrophilic polymer (1) (the following structure, Mw: 30,000) (solid content) 0.03 g
- Polyvinyl alcohol (CKS50, manufactured by Nippon Synthetic Chemical Industry Co., Ltd., 0.10 g
  sulfonic acid-modified, saponification degree: 99% by mole or greater, degree of polymerization: 300) 6 mass% aqueous solution
- Polyvinyl alcohol (PVA-405, manufactured by KURARAY CO., LTD., 0.03 g
  saponification degree: 81.5% by mole, degree of polymerization: 500), 6 mass% aqueous solution
- Surfactant (EMALEX 710, manufactured by Nihon Emulsion Co., Ltd.) 0.86 g
  (the following structure) 1 mass% aqueous solution
- Ion exchange water 6.0 g

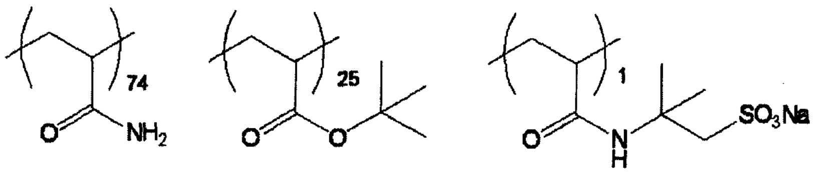

Hydrophilic polymer (1)

$$C_{12}H_{25}—(OCHCH_2)_{10}—OH$$

EMALEX 710

(Preparation of inorganic layered compound dispersion liquid (1))

6.4 g of synthetic mica Somasif ME-100 (manufactured by CO-OP CHEMICAL CO., LTD.) was added to 193.6 g of ion exchange water and dispersed such that the volume average particle diameter (laser scattering method) was set to 3 μm using a homogenizer. The aspect ratio of the obtained dispersed particles was 100 or greater.

[Preparation of planographic printing plate precursors 102 to 111]

Planographic printing plate precursors 102 to 111 were prepared in the same manner as that for the planographic printing plate precursor 101 except that the type of metal oxide in the back coat layer coating solution, the type, the average particle diameter, and the addition amount of fine particles, and the thickness of the back coat layer were changed as listed in Table F.

[Preparation of planographic printing plate precursor 112]

<Formation of image recording layer>

The undercoat layer of the support having the undercoat layer and the back coat layer used for preparation of the planographic printing plate precursor 1 was bar-coated with an image recording layer coating solution (2) having the following composition and dried in an oven at 70° for 60 seconds, thereby forming an image recording layer having a drying coating amount of 0.6 $g/m^2$. In this manner, a planographic printing plate precursor 112 was prepared.

(Image recording layer coating solution (2))

- Thermoplastic polymer fine particle aqueous dispersion liquid (described below) 20.0 g
- Infrared absorbing agent (2) (the following structure) 0.2 g
- Polymerization initiator (IRGACURE 250, manufactured by Ciba Specialty Chemicals, Inc.) 0.4 g
- Polymerization initiator (2) (the following structure) 0.15 g
- Polymerizable compound SR-399 (manufactured by Sartomer Japan Inc.) 1.50 g
- Mercapto-3-triazole 0.2 g
- Byk336 (manufactured by BYK Chemie GmbH) 0.4 g
- Klucel M (manufactured by Hercules, Inc.) 4.8 g
- ELVACITE 4026 (manufactured by Ineos Acrylics Ltd.) 2.5 g
- Anionic surfactant 1 (the above-described structure) 0.15 g
- n-propanol 55.0 g
- 2-butanone 17.0 g

The compounds described with the trade names in the composition above as follows.

- IRGACURE 250: (4-methylphenyl)[4-(2-methylpropyl)phenyl]iodonium=hexafluorophosphate (75 mass% propylene carbonate solution)
- SR-399: dipentaerythritolpentaacrylate
- Byk336: modified dimethyl polysiloxane copolymer (25 mass% xylene/methoxy propyl acetate solution)

- Klucel M: hydroxypropyl cellulose (2 mass% aqueous solution)
- ELVACITE 4026: highly branched polymethyl methacrylate (10 mass% 2-butanone solution)

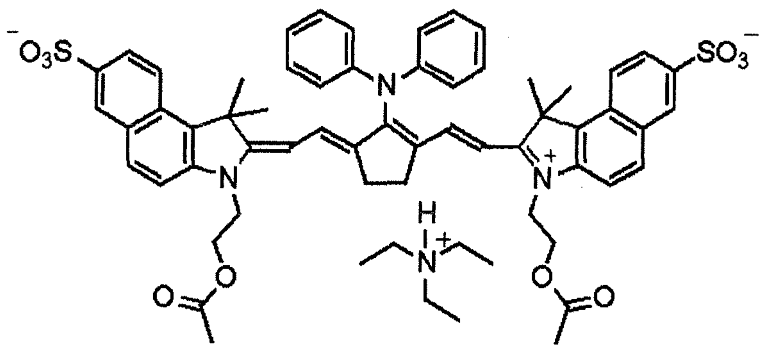

Infrared absorbent (2)

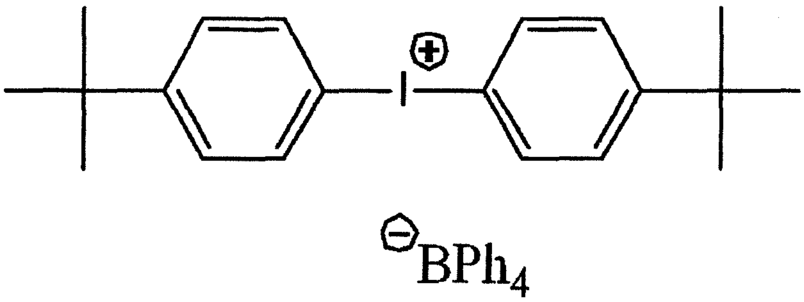

Polymerization initiator (2)

(Preparation of thermoplastic polymer fine particle aqueous dispersion liquid)

Nitrogen gas was introduced into a 1,000 ml four-necked flask equipped with a stirrer, a thermometer, a dropping funnel, a nitrogen introduction pipe, and a reflex condenser, deoxygenation was performed, 10 g of polyethylene glycol methyl ether methacrylate (PEGMA, average number of repeating units of ethylene glycol: 20), 200 g of distilled water, and 200 g of n-propanol were added thereto, and then the mixture was heated until the internal temperature thereof was set to 70°C. Next, a mixture of 10 g of styrene (St), 80 g of acrylonitrile (AN), and 0.8 g of 2,2'-azobisisobutyronitrile prepared in advance was added dropwise for 1 hour. After dropwise addition was finished, the reaction was allowed to be continued for 5 hours, 0.4 g of 2,2'-azobisisobutyronitrile was added thereto, and the mixture was heated until the internal temperature was set to 80°C. Subsequently, 0.5 g of 2,2'-azobisisobutyronitrile was added for 6 hours. The total degree of polymerization at the stage of the continued reaction for 20 hours was 98% or greater, and a thermoplastic polymer fine particle aqueous dispersion liquid having PEGMA, St, and AN at a mass ratio of 10/10/80 was obtained. The particle size distribution of the thermoplastic polymer fine particle has a maximum value at 150 nm of the volume average particle diameter.

Here, the particle size distribution was acquired by imaging an electron micrograph of polymer fine particles, measuring the total number of 5,000 particle diameters of fine particles on the photograph, dividing the interval from the maximum value of the obtained measured value of the particle diameter to 0 into the logarithmic scale of 50, and plotting the appearance frequency of each particle diameter. Further, the particle diameter of a spherical particle having the same particle area as the particle area on the photograph was set to the particle diameter, as non-spherical particles.

[Preparation of planographic printing plate precursor 113]

<Preparation of support 2>

An aluminum plate having a thickness of 0.19 mm was immersed in a 40 g/L sodium hydroxide aqueous solution at 60°C for 8 seconds so as to be degreased and then washed with demineralized water for 2 seconds. Next, the

aluminum plate was subjected to an electrochemical roughening treatment in an aqueous solution containing 12 g/L of hydrochloric acid and 38 g/L of aluminum sulfate (18 hydrate) at a temperature of 33°C and at a current density of 130 A/dm$^2$ using an AC for 15 seconds. Next, the aluminum plate was washed with demineralized water for 2 seconds, subjected to a desmutting treatment by being etched using 155 g/L of a sulfuric acid aqueous solution at 70°C for 4 seconds, and washed with demineralized water at 25°C for 2 seconds. The aluminum plate was subjected to an anodizing treatment in 155 g/L of a sulfuric acid aqueous solution for 13 seconds at a temperature of 45°C and at a current density of 22 A/dm$^2$ and washed with demineralized water for 2 seconds. Further, the aluminum plate was treated at 40°C for 10 seconds using 4 g/L of a polyvinyl phosphonic acid aqueous solution, washed with demineralized water at 20°C for 2 seconds, and then dried, thereby preparing a support 2. The surface roughness Ra of the support 2 was 0.21 μm and the amount of the anodized film was 4 g/m$^2$.

<Formation of back coat layer>

One surface of the support 2 was bar-coated with the back coat layer coating solution (1) and dried at 100°C for 120 seconds, thereby forming a back coat layer having a thickness of 1.5 μm.

<Formation of image recording layer>

An image recording layer aqueous coating solution containing thermoplastic polymer fine particles, an infrared absorbing agent, and polyacrylic acid described below was prepared, the pH thereof was adjusted to 3.6, and the other surface of the support 2 was coated with the coating solution and dried at 50°C for 1 minute to form an image recording layer, thereby preparing a planographic printing plate precursor 113. The coating amount after the drying of each component is shown below.

Thermoplastic polymer fine particles: 0.7 g/m$^2$
Infrared absorbing agent IR-01: 1.20 × $10^{-4}$ g/m$^2$
Polyacrylic acid: 0.09 g/m$^2$

The thermoplastic polymer fine particles, the infrared absorbing agent IR-01, the polyacrylic acid used for the image recording layer coating solution are as follows.

Thermoplastic polymer fine particles: styrene-acrylonitrile copolymer (molar ratio of 50:50), Tg: 99°C, volume average particle diameter: 60 nm

Infrared absorbing agent IR-01: infrared absorbing agent having the following structure

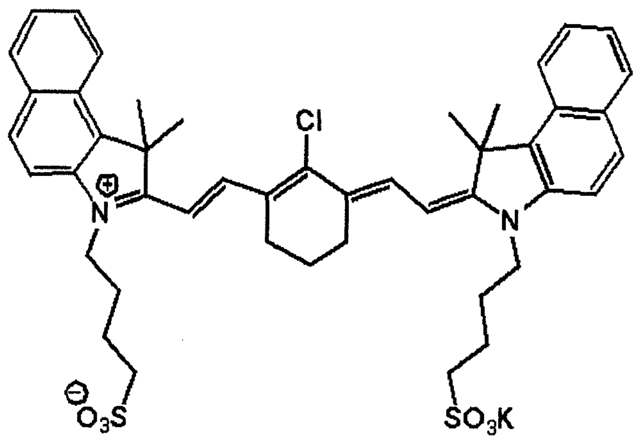

Polyacrylic acid Mw: 250000

[Preparation of planographic printing plate precursor 114]

<Formation of back coat layer>

One surface of a polyethylene terephthalate film having a thickness of 180 μm which was biaxially stretched (the stretching ratios in the longitudinal direction and the transverse direction were both 3.3 times) and heat-fixed at

240°C for 3 minutes was subjected to a corona discharge treatment, and the back coat layer coating solution (1) was bar-coated and dried at 100°C for 120 seconds, thereby forming a back coat layer having a thickness of 1.5 μm.

<Formation of image recording layer>

After the other surface of the polyethylene terephthalate film was subjected to a corona discharge treatment at 8 $W/m^2$, an image recording layer was formed in the same manner as the preparation of the planographic printing plate precursor 1 using the image recording layer coating solution (1).

<Formation of protective layer>

A protective layer was formed on the image recording layer in the same manner as the preparation of the planographic printing plate precursor 1 using the protective layer coating solution (1), thereby preparing a planographic printing plate precursor 114.

[Preparation of planographic printing plate precursor 115] (for comparison)

A back coat layer was formed in the same manner as the preparation of the planographic printing plate precursor 101 except that the thickness of the back coat layer was changed to 10 μm, thereby preparing a planographic printing plate precursor 115.

[Preparation of planographic printing plate precursor 116] (for comparison)

A back coat layer was formed in the same manner as the preparation of the planographic printing plate precursor 109 except that the metal oxide in the back coat layer coating solution was changed into a polyester resin (KEMIT K-588, manufactured by Toray Industries, Inc., Tg: 100°C), thereby preparing a planographic printing plate precursor 116.

[Preparation of planographic printing plate precursor 117] (for comparison)

A back coat layer was formed in the same manner as the preparation of the planographic printing plate precursor 109 except that the metal oxide in the back coat layer coating solution was changed into acrylic acid ester-based polymer latex (AE-337, manufactured by JSR CORPORATION, Tg: -30°C), thereby preparing a planographic printing plate precursor 117.

[Preparation of planographic printing plate precursor 118] (for comparison)

A back coat layer was formed in the same manner as the preparation of the planographic printing plate precursor 114 except that the metal oxide in the back coat layer coating solution was changed into acrylic acid ester-based polymer latex (AE-337, manufactured by JSR CORPORATION, Tg: -30°C), thereby preparing a planographic printing plate precursor 118.

[Preparation of planographic printing plate precursor 119] (for comparison)

A back coat layer was formed in the same manner as the preparation of the planographic printing plate precursor 101 except that the fine particles in the back coat layer coating solution were removed, thereby preparing a planographic printing plate precursor 119.

[Preparation of planographic printing plate precursor 120] (for comparison)

A back coat layer was formed in the same manner as the preparation of the planographic printing plate precursor 118 except that the fine particles in the back coat layer coating solution were removed, thereby preparing a planographic printing plate precursor 120.

[Preparation of planographic printing plate precursor 121] (for comparison)

A back coat layer was formed in the same manner as the preparation of the planographic printing plate precursor 117 except that the fine particles in the back coat layer coating solution were removed, thereby preparing a planographic printing plate precursor 121.

[Evaluation of planographic printing plate precursor]

The mat dropping, adhesiveness, scratches, scars, and Bekk smoothness of each of the obtained planographic printing plate precursors were evaluated. The evaluation results were listed in Table F.

<Mat dropping>

The rear surface (back coat layer side) of the planographic printing plate precursor was placed upward, a piece of ethylene propylene diene rubber (EDPM) having a length of 2 cm and a width of 2 cm was put on the rear surface, and the rubber piece was drawn to the front side while applying a 1 kg load. Thereafter, the rear surface of the planographic printing plate precursor was observed using a scanning electron microscope, 5 sites of predetermined visual fields (200 μm × 300 μm) were observed, and the proportion of dropped fine particles was measured. The evaluation was performed based on the following standard. The value of 3 is a practical lower limit level and the value of 2 or less is a practically unacceptable level.

5: The proportion of dropped fine particles was 0%.
4: The proportion of dropped fine particles was 0%, but fine particles partially not covering the back coat layer were present.
3: The proportion of dropped fine particles was greater than 0% and less than or equal to 25%.
2: The proportion of dropped fine particles was greater than 25% and less than or equal to 75%.
1: The proportion of dropped fine particles was greater than 75% and less than or equal to 100%.

<Adhesiveness>

The humidity of three planographic printing plate precursors (10 × 10 cm) was adjusted in an environment of 25°C at a relative humidity of 75% for 2 hours, and the precursors were sequentially stacked in the same direction in a state in which interleaving paper was not interposed between precursors, thereby obtaining a laminate. This laminate was tightly wrapped with kraft paper having an aluminum laminate layer and then allowed to stand still in an environment of 30 °C for 5 days in a state in which a 4 kg load was applied thereto. Thereafter, the planographic printing plate precursors were peeled off, and the state of adhesion between the surface of the planographic printing plate precursor on the image recording layer side and the surface of the planographic printing plate precursor adjacent thereto on the support side was visually observed. The evaluation was performed based on the following standard. The value of 3 is a practical lower limit level and the value of 2 or less is a practically unacceptable level.

5: The precursors were not bonded to each other.
4: The precursors were slightly bonded to each other.
3: The precursors were partially bonded to each other.
2: The precursors were strongly bonded to each other to the extent that the precursors were peeled off from each other by hand in a case where strength was applied thereto.
1: The precursors were extremely and strongly bonded to each other so that the precursors were unlikely to be peeled off from each other.

<Scratches>

After the humidity of the planographic printing plates was adjusted in an environment of 25° at a relative humidity of 60% for 2 hours, a precursor was punched into a size of 2.5 cm × 2.5 cm and attached to a continuous load type scratch strength tester TYPE: 18 (manufactured by SHINTO Scientific Co., Ltd.), the rear surface of the planographic printing plate precursor which had been punched was set to be brought into contact with the surface of the planographic printing plate precursor which has not been punched, and several sites of the planographic printing plate precursor were scratched by applying a 500 gf load. The scratched planographic printing plate was set by Trendsetter 3244 (manufactured by Creo Co., Ltd.) and then image-exposed under conditions of resolution of 2400 dpi, an output of 7 W, an external surface drum rotation speed of 150 rpm, and a plate surface energy of 110 mJ/cm$^2$. The planographic printing plate precursor after image exposure was mounted on an offset rotary printing press (manufactured by TOKYO KIKAI SEISAKUSHO, LTD.), and printing was performed on newsprint paper at a speed of 100,000 sheets/hour using SOIBI KKST-S (red) (manufactured by InkTec Corporation) as printing ink for newspaper and ECO SEVEN N-1 (manufactured by TOYO INK CO., LTD.) as dampening water. In the above-described printing process, 1,000-th printed matter was sampled, the degree of flaws and dirt caused by scratches was visually observed. The evaluation was performed based on the following standard. The value of 3 is a practical lower limit level and the value of 2 or less is a practically unacceptable

level.

5: Flaws and dirt were not found.
4: Although flaws and dirt were not confirmed by visual recognition, but flaws and dirt which were able to be confirmed using a 6 magnification loupe were found at one site.
3: Although flaws and dirt were not confirmed by visual recognition, but flaws and dirt which were able to be confirmed using a 6 magnification loupe were found at several sites.
2: Flaws and dirt which were able to be confirmed by visual recognition were found at several sites.
1: Flaws and dirt were found from the entire surface.

<Scars>

The humidity of ten planographic printing plate precursors (10 × 65 cm) was adjusted in an environment of 25°C at a relative humidity of 60% for 2 hours, and the precursors were sequentially stacked in the same direction in a state in which interleaving paper was not interposed between precursors, thereby obtaining a laminate. This laminate was tightly wrapped with kraft paper having an aluminum laminate layer, interposed between stainless steel (SUS) plates having a size of 5 cm × 5 cm, and pressed using a vise such that a 500 kgf load was applied thereto. The laminate was allowed to stand still in an environment of 25°C for 5 days in a state of being pressed. Thereafter, the planographic printing plate precursors were exposed to light, developed, and printed under the same conditions for the evaluation of scratches. In the above-described printing process, 1,000-th printed matter was sampled, the degree of flaws and dirt caused by scars was visually observed. The evaluation was performed based on the following standard. The value of 3 is a practical lower limit level and the value of 2 or less is a practically unacceptable level.

5: Dirt was not found.
4: Although flaws and dirt were not confirmed by visual recognition, but flaws and dirt which were able to be confirmed using a 6 magnification loupe were partially found.
3: Although flaws and dirt were not confirmed by visual recognition, but flaws and dirt which were able to be confirmed using a 6 magnification loupe were found from the entire surface.
2: Dirt which was able to be visually recognized was partially found.
1: Dirt which was able to be visually recognized was found from the entire surface.

<Bekk smoothness>

The Bekk smoothness of the rear surface of the planographic printing plate precursor (the surface of the back coat layer) was measured in conformity with JIS P8119 (1998). The measurement was performed at one tenth the amount of standard air, that is, an air amount of 1 ml using a Bekk smoothness tester (manufactured by KUMAGAI RIKI KOGYO Co., Ltd.). From the viewpoint of preventing the dislocation in stacking planographic printing plate precursors, the Bekk smoothness is preferably 200 seconds or shorter, more preferably 100 seconds or shorter, and still more preferably 50 seconds or shorter.

[Table 7]

Table F

| | Planographic printing plate precursor | Metal oxide of back coat layer | Fine particles of back coat layer | | | Thickness of back coat layer (μm) | Evaluation results | | | | |
|---|---|---|---|---|---|---|---|---|---|---|---|
| | | | Type | Average particle diameter (μm) | Addition amount (mg/m²) | | Mat dropping | Adhesive ness | Scars | Scratches | Bekk smoothness (sec) |
| Example 101 | 101 | Metal oxide 1 | Silica-coated acrylic resin particles | 6 | 50 | 1.5 | 5 | 5 | 5 | 5 | 10 |
| Example 102 | 102 | Metal oxide 1 | Silica-coated acrylic resin particles | 6 | 20 | 1.5 | 5 | 5 | 5 | 5 | 12 |
| Example 103 | 103 | Metal oxide 1 | Silica-coated acrylic resin particles | 6 | 100 | 1.5 | 5 | 5 | 5 | 5 | 5 |
| Example 104 | 104 | Metal oxide 1 | Silica-coated acrylic resin particles | 6 | 50 | 3.5 | 5 | 5 | 5 | 5 | 20 |
| Example 105 | 105 | Metal oxide 1 | Silica-coated acrylic resin particles | 6 | 50 | 5.5 | 5 | 5 | 5 | 4 | 67 |
| Example 106 | 106 | Metal oxide 1 | Silica-coated acrylic resin particles | 6 | 50 | 0.1 | 4 | 5 | 5 | 5 | 10 |
| Example 107 | 107 | Metal oxide 1 | Silica-coated melamine resin particles | 6.5 | 50 | 1.5 | 5 | 5 | 5 | 5 | 9 |
| Example 108 | 108 | Metal oxide 1 | Silica-coated urethane resin particles | 6 | 50 | 1.5 | 5 | 5 | 5 | 5 | 12 |
| Example 109 | 109 | Metal oxide 1 | Acrylic resin particles | 6 | 50 | 1.5 | 3 | 5 | 5 | 3 | 22 |

(continued)

| | Planographic printing plate precursor | Metal oxide of back coat layer | Fine particles of back coat layer | | | Thickness of back coat layer (μm) | Evaluation results | | | | |
|---|---|---|---|---|---|---|---|---|---|---|---|
| | | | Type | Average particle diameter (μm) | Addition amount (mg/m$^2$) | | Mat dropping | Adhesive ness | Scars | Scratches | Bekk smoothness (sec) |
| Example 110 | 110 | Metal oxide 1 | Polyethylene resin particles | 6 | 50 | 1.5 | 3 | 5 | 5 | 3 | 22 |
| Example 111 | 111 | Metal oxide 1 | Polystyrene resin particles | 5 | 50 | 1.5 | 3 | 5 | 5 | 3 | 33 |
| Example 112 | 112 | Metal oxide 1 | Silica-coated acrylic resin particles | 6 | 50 | 1.5 | 5 | 5 | 5 | 5 | 10 |
| Example 113 | 113 | Metal oxide 1 | Silica-coated acrylic resin particles | 6 | 50 | 1.5 | 5 | 5 | 5 | 5 | 8 |
| Example 114 | 114 | Metal oxide 1 | Silica-coated acrylic resin particles | 6 | 50 | 1.5 | 5 | 5 | 5 | 5 | 10 |
| Comparative Example 101 | 115 | Metal oxide 1 | Silica-coated acrylic resin particles | 6 | 50 | 10 | 5 | 5 | 5 | 1 | 350 |
| Comparative Example 102 | 116 | Polyester resin 1 | Acrylic resin particles | 6 | 50 | 1.5 | 5 | 5 | 5 | 2 | 25 |
| Comparative Example 103 | 117 | Polymer latex 1 | Acrylic resin particles | 6 | 50 | 1.5 | 5 | 2 | 2 | 5 | 16 |
| Comparative Example 104 | 118 | Polymer latex 1 | Silica-coated acrylic resin particles | 6 | 50 | 1.5 | 5 | 2 | 2 | 5 | 18 |
| Comparative Example 105 | 119 | Metal oxide 1 | - | - | - | 1.5 | - | 5 | 5 | 1 | 370 |
| Comparative Example 106 | 120 | Polymer latex 1 | - | - | - | 1.5 | - | 2 | 2 | 2 | 415 |

(continued)

| | Planographic printing plate precursor | Metal oxide of back coat layer | Fine particles of back coat layer | | | Thickness of back coat layer (μm) | Evaluation results | | | | |
|---|---|---|---|---|---|---|---|---|---|---|---|
| | | | Type | Average particle diameter (μm) | Addition amount ($mg/m^2$) | | Mat dropping | Adhesive ness | Scars | Scratches | Bekk smoothness (sec) |
| Comparative Example 107 | 121 | Polymer latex 1 | - | - | - | 1.5 | - | 2 | 2 | 2 | 400 |

Respective components used for the back coat layers listed in Table F are as follows.
Polyester resin 1: KEMIT K-588, manufactured by Toray Industries, Inc., (Tg: 100°C)
Polymer latex 1: acrylic acid ester-based polymer latex (AE-337, manufactured by JSR CORPORATION, (Tg: -30°C)
Silica-coated acrylic resin particles: ART PEARL J-7P, manufactured by Negami Chemical Industrial Co., Ltd.
Silica-coated acrylic resin particles: OPTBEADS 6500M, manufactured by Nissan Chemical Industries, Ltd.
Silica-coated acrylic resin particles: ART PEARL C-800T, manufactured by Negami Chemical Industrial Co., Ltd.
Acrylic resin particles: MX-500, manufactured by Soken Chemical & Engineering Co., Ltd.
Polyethylene resin particles: CHEMIPEARL W200, manufactured by Mitsui Chemicals, Inc.
Polyethylene resin particles: CHEMISNOW SX-500H, manufactured by Soken Chemical & Engineering Co., Ltd.

From the results listed in Table F, it was understood that the planographic printing plate precursors respectively having the back coat layer containing a specific metal oxide and specific fine particles according to the present invention were excellent in all evaluations of the mat dropping, the adhesiveness, the scratches, and the scars and dislocation in stacking precursors did not occur even in a case where the lamination was made without interleaving paper. On the contrary, the planographic printing plate precursors of the comparative examples, which respectively had the back coat layer not satisfying the requirements according to the present invention were insufficient in any evaluations of the mat dropping, the adhesiveness, the scratches, and the scars and dislocation in stacking precursors.

[Examples 201 to 207 and Comparative Example 201]

[Preparation of planographic printing plate precursors 201 to 207]

Planographic printing plate precursors 201 to 207 were prepared in the same manner as that for the planographic printing plate precursor 101 except that the type of metal oxide in the back coat layer coating solution, the type, the average particle diameter, and the addition amount of fine particles, and the thickness of the back coat layer were changed as listed in Table G.

[Preparation of planographic printing plate precursor 208] (for comparison)

A planographic printing plate precursor 208 was prepared in the same manner as the preparation of the planographic printing plate precursor 203 except that the thickness of the back coat layer was changed into 3.5 μm.

[Evaluation of planographic printing plate precursor]

The mat dropping, adhesiveness, scratches, scars, and Bekk smoothness of each of the obtained planographic printing plate precursors were evaluated in the same manner as in Example 101. The evaluation results were listed in Table G

[Table 8]

Table G

| | Planographic printing plate precursor | Metal oxide of back coat layer | Fine particles of back coat layer | | | Thickness of back coat layer (µm) | Evaluation results | | | | |
|---|---|---|---|---|---|---|---|---|---|---|---|
| | | | Type | Average particle diameter (µm) | Addition amount (mg/m$^2$) | | Mat dropping | Adhesiveness | Scars | Scratches | Bekk smoothness (sec) |
| Example 201 | 201 | Metal oxide 1 | Silica particles 1 | 6 | 50 | 1.5 | 5 | 5 | 4 | 5 | 12 |
| Example 202 | 202 | Metal oxide 1 | Silica particles 2 | 4 | 50 | 1.5 | 5 | 5 | 4 | 5 | 25 |
| Example 203 | 203 | Metal oxide 1 | Silica particles 3 | 2 | 50 | 1.5 | 5 | 5 | 5 | 4 | 72 |
| Example 204 | 204 | Metal oxide 1 | Silica particles 3 | 2 | 50 | 0.3 | 5 | 5 | 4 | 5 | 35 |
| Example 205 | 205 | Metal oxide 1 | Silica particles 1 | 6 | 50 | 0.1 | 4 | 5 | 3 | 4 | 10 |
| Example 206 | 206 | Metal oxide 1 | Silica particles 1 | 6 | 20 | 1.5 | 5 | 5 | 4 | 5 | 25 |
| Example 207 | 207 | Metal oxide 1 | Silica particles 1 | 6 | 5 | 1.5 | 5 | 5 | 5 | 4 | 45 |
| Comparative Example 201 | 208 | Metal oxide 1 | Silica particles 3 | 2 | 50 | 3.5 | 3 | 5 | 5 | 1 | 310 |

Respective components used for the back coat layers listed in Table G are as follows.
Silica particles 1: SYLYSIA 440, manufactured by FUJI SILYSIACHEMICAL LTD.
Silica particles 2: SYLYSIA 436, manufactured by FUJI SILYSIACHEMICAL LTD.
Silica particles 3: SYLYSIA 320, manufactured by FUJI SILYSIACHEMICAL LTD.
From the results listed in Table G, it was understood that the planographic printing plate precursors respectively having the back coat layer containing a specific metal oxide and specific fine particles according to the present invention were excellent in all evaluations of the mat dropping, the adhesiveness, the scratches, and the scars and dislocation in stacking precursors did not occur even in a case where the lamination was made without interleaving paper. On the contrary, the planographic printing plate precursors of the comparative examples, which respectively had the back coat layer not satisfying the requirements according to the present invention were insufficient in any evaluations of the mat dropping, the adhesiveness, the scratches, and the scars and dislocation in stacking precursors.

[Examples 301 and 302]

[Preparation of planographic printing plate precursor 301]

<Formation of undercoat layer>

The other surface (the surface which did not have the back coat layer) of the support having the back coat layer used for the preparation of the planographic printing plate precursor 101 was coated with an undercoat layer coating solution (2) having the following composition using a wire bar and dried at 90°C for 30 seconds. The coating amount thereof was 10 mg/$m^2$.

(Undercoat layer coating solution (2))

- Polymer compound A (the following structure) (mass average molecular weight: 30000) 0.05 g
- Methanol 27 g
- Ion exchange water 3 g

Polymer compound A

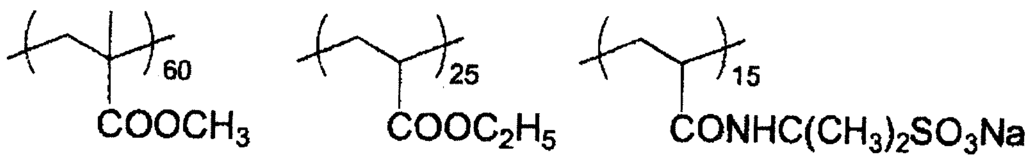

<Formation of image recording layer>

The undercoat layer was coated with the image recording layer coating solution (3) having the following composition using a wire bar and dried at 115°C for 34 seconds using a hot air dryer. The coating amount after the drying was 1.4 g/$m^2$.
(Image recording layer coating solution (3))

- Infrared absorbent (IR-1) (the following structure) 0.074 g
- Polymerization initiator (OS-12) (the following structure) 0.280 g
- Additive (PM-1) (the following structure) 0.151 g
- Polymerizable compound (AM-1) (the following structure) 1.00 g
- Binder polymer (BT-1) (the following structure) 1.00 g
- Ethyl violet (BT-1) (the following structure) 0.04 g
- Fluorine-based surfactant 0.015 g
  (MEGAFACE F-780-F, manufactured by DIC Corporation, 30 mass% solution of methyl isobutyl ketone (MIBK)
- Methyl ethyl ketone 10.4 g

- Methanol 4.83 g
- 1-methoxy-2-propanol 10.4 g

(OS-12)

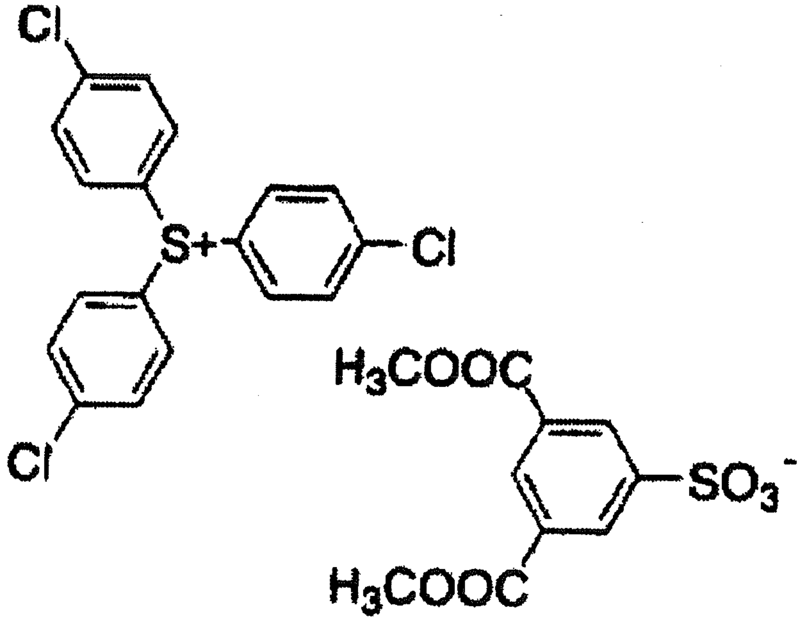

(IR-1)

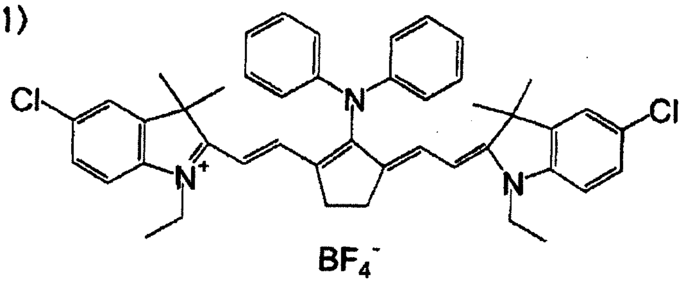

(PM-1)

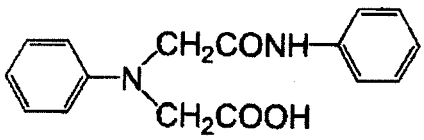

(AM-1)

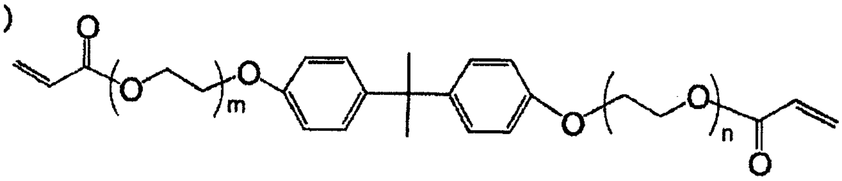

m + n ≒ 4

(BT-1)

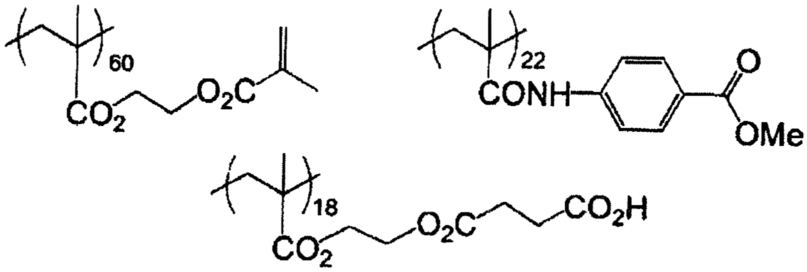

(C-1)

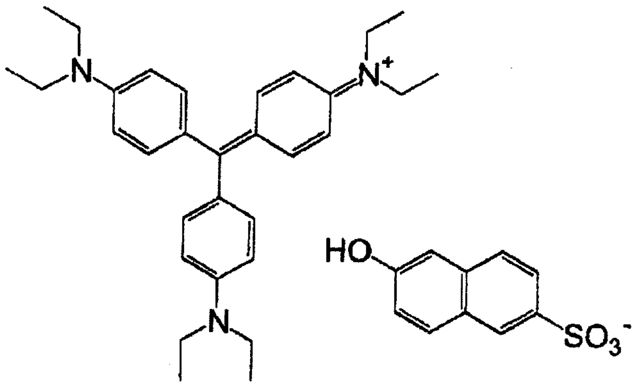

<Formation of protective layer>

The image recording layer was coated with the protective layer coating solution (2) having the following composition using a wire bar and dried at 125°C for 75 seconds using a hot air dryer, thereby forming a protective layer. The coating amount after the drying was 1.6 g/$m^2$. In this manner, a planographic printing plate precursor 301 was prepared.

<Protective layer coating solution (2)>

- Synthetic mica (SOMASIF ME-100, manufactured by CO-OP CHEMICAL CO., LTD., 8% aqueous dispersion liquid) 94 g
- Polyvinyl alcohol (CKS-50, manufactured by Nippon Synthetic Chemical Industry Co, Ltd., degree of saponification of 99% by mole, degree of polymerization of 300) 58 g
- Carboxy methyl cellulose (CELOGEN PR, manufactured by DKS Co., Ltd.) 24 g
- Surfactant-1 (PLURONIC P-84, manufactured by BASF SE) 2.5 g
- Surfactant-2 (EMALEX 710, manufactured by Nihon Emulsion Co., Ltd.) 5g
- Pure water 1364 g

[Preparation of planographic printing plate precursor 302]

<Formation of undercoat layer>

The other surface (the surface which did not have the back coat layer) of the support having the back coat layer used for the preparation of the planographic printing plate precursor 101 was coated with an undercoat layer coating solution (3) having the following composition using a wire bar and dried at 80°C for 15 seconds, thereby forming an undercoat layer. The coating amount after the drying was 18 mg/$m^2$.

(Undercoat layer coating solution (3))

- Polymer compound (the following structure) 0.3 g

- Methanol 100 g

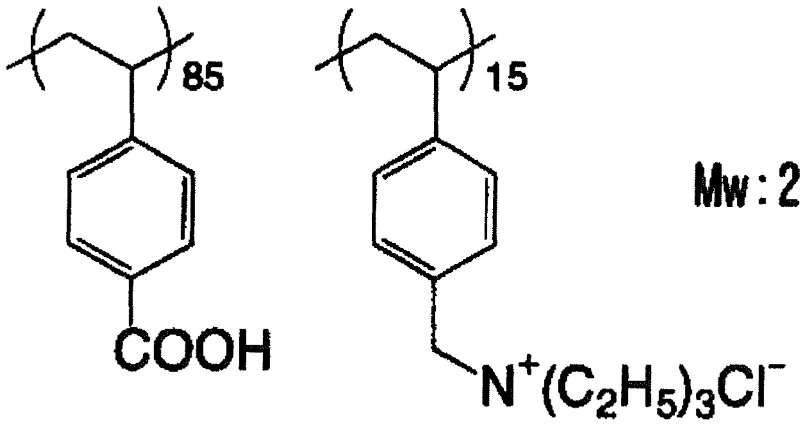

Mw:28, 000

<Formation of image recording layer>

The undercoat layer was coated with an underlayer coating solution having the following composition using a bar coater such that the coating amount after the drying was set to 0.85 g/m2, dried at 160°C for 44 seconds, and immediately cooled with cold air in a temperature range of 17°C to 20°C until the temperature of the support was set to 35°C, thereby forming an underlayer. Thereafter, the underlayer was coated with an upper layer coating solution having the following composition using a bar coater such that the coating amount after the drying was set to 0.22 g/$m^2$, dried at 148°C for 25 seconds, and gradually cooled with air in a temperature range of 20°C to 26°C, thereby forming an upper layer. In this manner, a planographic printing plate precursor 302 was prepared.

(Underlayer coating solution)

- N-(4-aminosulfonylphenyl)methacrylamide/acrylonitrile/methyl methacrylate 2.1 g
  (36/34/30% by mass: mass average molecular weight of 50000, acid value of 2.65)
- m,p-cresol novolac 0.1 g
  (m/p ratio = 6/4, mass average molecular weight of 4500, containing 0.8% by mass of unreacted cresol, Tg: 75°C)
- Cyanine dye A (the following structure) 0.13 g
- 4,4'-bishydroxyphenylsulfone 0.13 g
- Tetrahydrophthalic anhydride 0.19 g
- p-toluenesulfonic acid 0.008 g
- 3-methoxy-4-diazodiphenylamine Hexafluorophosphate 0.032 g
- Dye obtained by changing counter ion of ethyl violet into 6-hydroxy-2-naphthalenesulfonic acid 0.078 g
- Fluorine-based surfactant B (the following structure) 0.007 g
- Methyl ethyl ketone 25.0 g
- 1-methoxy-2-propanol 13.0 g
- γ-butyrolactone 13.0 g

Cyanine dye A

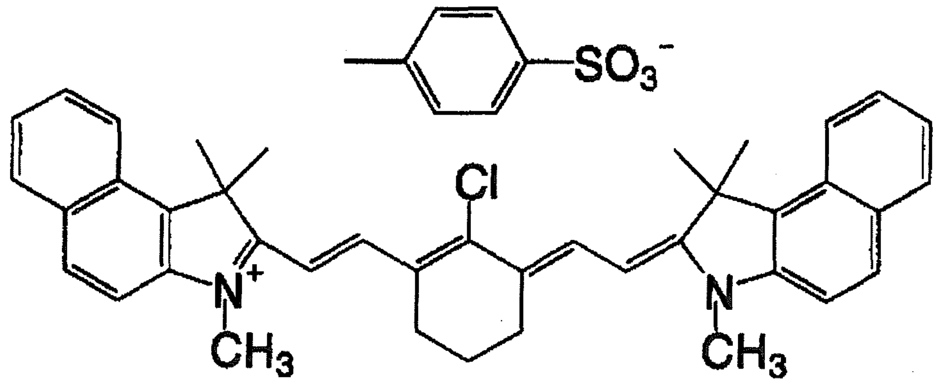

Fluorine-based surfactant B

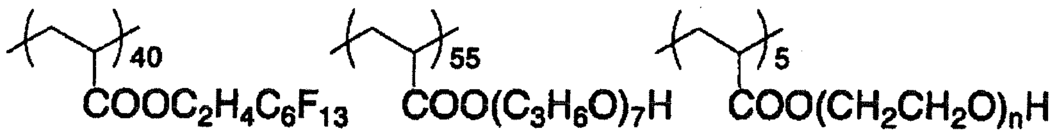

Mw:35, 000

(Upper layer coating solution)

- Phenol/m-cresol/p-cresol novolac 0.35 g
  (molar ratio = 5/3/2, mass average molecular weight: 5000, containing 1.2% by mass of unreacted cresol, Tg: 70°C)
- Acrylic resin C (the following structure) 0.042 g
- Cyanine dye A (the following structure) 0.019 g
- Ammonium compound D (the following structure) 0.004 g
- Sulfonium compound G (the following structure) 0.032 g
- Fluorine-based surfactant B (the following structure) 0.0045 g
- Fluorine-based surfactant E (the following structure) 0.0033 g
- Fluorine-based polymer F (the following structure) 0.018 g
- Methyl ethyl ketone 10.0 g
- 1-methoxy-2-propanol 20.0 g

Acrylic resin C

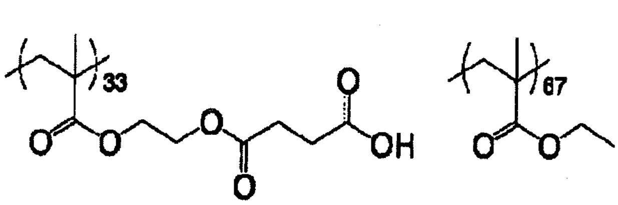

Mw:100, 000

Ammonium compound D

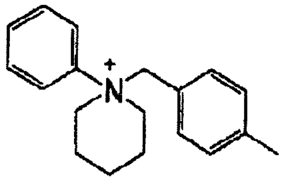 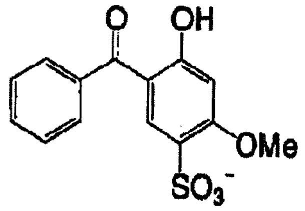

Fluorine-based surfactant E

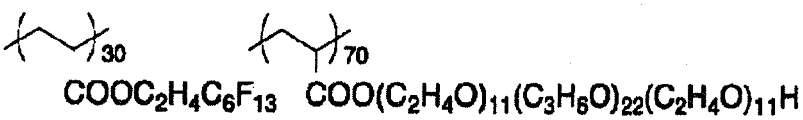

Mw:35, 000

Fluorine-based polymer F (X:Y:Z=36:34:30)

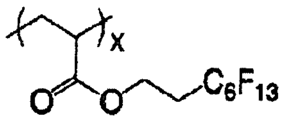 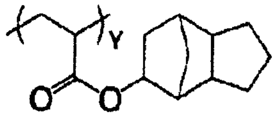

Mw:70, 000

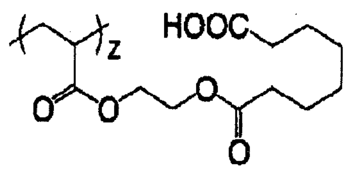

Sulfonium compound G

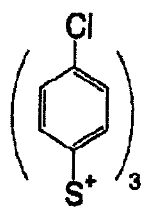 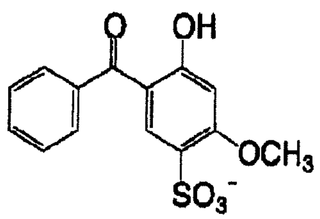

[Evaluation of planographic printing plate precursor]

The mat dropping, adhesiveness, scratches, scars, and Bekk smoothness of each of the obtained planographic printing plate precursors were evaluated in the same manner as in Example 101. Here, the image exposure, the development treatment, and the printing in the evaluations of scratches and scars were performed in the following manner. The results were listed in Table H.

<Image exposure and development treatment performed on development treatment type negative type planographic printing plate precursor 301>

(Image exposure)

The planographic printing plate was set by Trendsetter 3244 (manufactured by Creo Co., Ltd.) and then image-exposed under conditions of resolution of 2400 dpi, an output of 7 W, an external surface drum rotation speed of 150 rpm, and a plate surface energy of 110 mJ/$cm^2$.

(Development treatment)

The image-exposed planographic printing plate precursor was subjected to a development treatment under conditions of a development temperature of 30°C at a transport speed (line speed) of 2 m/min using an automatic developer LP-1310HII (manufactured by Fujifilm Corporation). A 1:4 water-diluted solution of DH-N (manufactured by Fujifilm Corporation) was used as a developer, a 1:1.4 water-diluted solution of FCT-421 (manufactured by Fujifilm Corporation) was used as a development replenisher, and a 1:1 water-diluted solution of HN-GV (manufactured by Fujifilm Corporation) was used as a finisher.

<Image exposure and development treatment performed on development treatment type positive type planographic printing plate precursor 302>

(Image exposure)

The planographic printing plate was set by Trendsetter 3244 (manufactured by Creo Co., Ltd.) and then image-exposed under conditions of resolution of 2400 dpi, an output of 7 W, an external surface drum rotation speed of 150 rpm, and a plate surface energy of 110 mJ/$cm^2$.

(Development treatment)

A developer DT-2 (Fujifilm Corporation) was prepared by being diluted with water at a dilution ratio of 1:8 using an automatic developer LP-940HII (manufactured by Fujifilm Corporation) and the image-exposed planographic printing plate precursor was subjected to a development treatment at a development temperature of 32°C for a development time of 12 seconds.

(Printing)

The planographic printing plate precursor was mounted on an offset rotary printing press (manufactured by TOKYO KIKAI SEISAKUSHO, LTD.), and printing was performed on newsprint paper at a speed of 100,000 sheets/hour using SOIBI KKST-S (red) (manufactured by InkTec Corporation) as printing ink for newspaper and ECO SEVEN N-1 (manufactured by TOYO INK CO., LTD.) as dampening water.

[Table 9]

Table H

| | Planographic printing plate precursor | Metal oxide of back coat layer | Fine particles of back coat layer | | | Thickness of back coat (μm) | Evaluation results | | | | |
|---|---|---|---|---|---|---|---|---|---|---|---|
| | | | Type | Average particle diameter (μm) | Addition amount ($mg/m^2$) | | Mat dropping | Adhesiveness | Scars | Scratches | Bekk smoothness (sec) |
| Example 301 | 301 | Metal oxide 1 | Silica-coated acrylic resin particles | 6 | 50 | 1.5 | 5 | 5 | 4 | 5 | 10 |
| Example 302 | 302 | Metal oxide 1 | Silica-coated acrylic resin particles | 6 | 50 | 1.5 | 5 | 5 | 4 | 5 | 12 |

From the results listed in Table H, it was understood that the development treatment type negative type planographic printing plate precursor 301 and the development treatment type positive type planographic printing plate precursor 302 respectively having the back coat layer containing a specific metal oxide and specific fine particles according to the present invention were excellent in all evaluations of the mat dropping, the adhesiveness, the scratches, and the scars and dislocation in stacking precursors did not occur even in a case where the lamination was made without interleaving paper.

[Examples 401 and 402]

[Preparation of blank plate precursor 401 for printing]

A blank plate precursor 401 for printing was prepared in the same manner as that for the planographic printing plate precursor 101 except that an infrared absorbent (1) was removed from the image recording layer coating solution (1).

[Preparation of blank plate precursor 402 for printing]

<Formation of undercoat layer>

The other surface (the surface which did not have the back coat layer) of the support having the back coat layer used for the preparation of the planographic printing plate precursor 101 was bar-coated with an undercoat layer coating solution (4) having the following composition and dried at 100°C for 20 seconds, thereby forming an undercoat layer. The coating amount after the drying was 20 mg/m$^2$.

<Undercoat layer coating solution (4)>

- Polymer (the following structure) 0.3 parts by mass
- Pure water 60.0 parts by mass
- Methanol 939.7 parts by mass

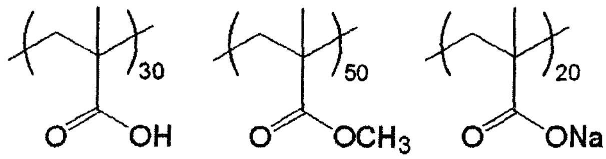

Mw = 31,000

<Formation of non-photosensitive layer>

The undercoat layer was bar-coated with a non-photosensitive layer coating solution (1) having the following composition and dried at 100°C for 60 seconds, thereby forming a non-photosensitive layer. The coating amount after the drying was 1.0 mg/m$^2$.

(Non-photosensitive layer coating solution (1))

- Binder polymer A (described below) 2.465 parts by mass
- Phosphoric acid (85 mass% aqueous solution) 0.08 parts by mass
- Sulfophthalic acid (50 mass% aqueous solution) 0.017 parts by mass
- Tricarballylic acid 0.017 parts by mass
- Colorant (VPB-Naps (naphthalene sulfonate of Victoria Pure Blue, manufactured by Hodagaya Chemical Co., Ltd.) 0.0014 parts by mass
- Fluorine-based surfactant (MEGAFACE F-780-F, manufactured by DIC Corporation, 30 mass% solution of MEK) 0.009 parts by mass
- Methyl ethyl ketone (MEK) 7.93 parts by mass

- Methanol 6.28 parts by mass
- 1-methoxy-2-propanol (MFG) 2.01 parts by mass

The binder polymer A is a 16 mass% solution having MFG and MEK at a mixing ratio of 1:1 for a condensation reaction product (mass average molecular weight: 85000, acid content: 1.64 meq/g) of four types of monomers (1) to (4) described below.

(1) 4,4-diphenylmethane diisocyanate 37.5% by mole
(2) hexamethylene diisocyanate 12.5% by mole
(3) 2,2-bis(hydroxymethyl)propionic acid 32.5% by mole
(4) tetraethylene glycol 17.5% by mole

<Formation of hydrophilic layer>

The non-photosensitive layer was bar-coated with a hydrophilic layer coating solution (1) having the following composition and dried at 125°C for 75 seconds, thereby forming a hydrophilic layer. The coating amount after the drying was 1.6 mg/$m^2$. In this manner, a planographic printing plate precursor 402 was prepared.

(Hydrophilic layer coating solution (1))

- Synthetic mica (SOMASIF ME-100, manufactured by CO-OP CHEMICAL CO., LTD., 8% aqueous dispersion liquid) 94 parts by mass
- Polyvinyl alcohol (CKS-50, manufactured by Nippon Synthetic Chemical Industry Co, Ltd., degree of saponification: 99% by mole, degree of polymerization: 300) 58 parts by mass
- Carboxy methyl cellulose (CELOGEN PR, manufactured by DKS Co., Ltd.) 24 parts by mass
- Surfactant-1 (PLURONIC P-84, manufactured by BASF SE) 2.5 parts by mass
- Surfactant-2 (EMALEX 710, manufactured by Nihon Emulsion Co., Ltd.) 5 parts by mass • Pure water 1364 parts by mass

PLURONIC P-84 described above is an ethylene oxide-propylene oxide block copolymer and EMALEX 710 is polyoxyethylene lauryl ether.

[Evaluation of blank plate precursor for printing]

The mat dropping, adhesiveness, scratches, scars, and Bekk smoothness of each of the obtained blank plate precursors for printing were evaluated in the same manner as in Example 101. Here, the image exposure for the evaluation of scratches and scars was not performed on the blank plate precursor 401 for printing, and then the printing was performed. Further, the image exposure for the evaluation of scratches and scars was not performed on the blank plate precursor 402 for printing, and then the following development treatment and printing were performed. The results were listed in Table I.

(Development treatment)

The blank plate precursor for printing was subjected to a development treatment under conditions of a development temperature of 30°C at a transport speed (line speed) of 2 m/min using an automatic developer LP-1310HII (manufactured by Fujifilm Corporation). A 1:4 water-diluted solution of HN-D (manufactured by Fujifilm Corporation) was used as a developer, a 1:1.4 water-diluted solution of FCT-421 (manufactured by Fujifilm Corporation) was used as a development replenisher, and a 1:1 water-diluted solution of HN-GV (manufactured by Fujifilm Corporation) was used as a finisher.

(Printing)

The blank plate precursor for printing was mounted on an offset rotary printing press (manufactured by TOKYO KIKAI SEISAKUSHO, LTD.), and printing was performed on newsprint paper at a speed of 100,000 sheets/hour using SOIBI KKST-S (red) (manufactured by InkTec Corporation) as printing ink for newspaper and ECO SEVEN N-1 (manufactured by TOYO INK CO., LTD.) as dampening water.

[Table 10]

Table I

| | Planographic printing plate precursor | Metal oxide of back coat layer | Fine particles of back coat layer | | | Thickness of back coat layer (μm) | Evaluation results | | | | |
|---|---|---|---|---|---|---|---|---|---|---|---|
| | | | Type | Average particle diameter (μm) | Addition amount (mg/m$^2$) | | Mat dropping | Adhesiveness | Scars | Scratches | Bekk smoothness (sec) |
| Example 401 | 401 | Metal oxide 1 | Silica-coated acrylic resin particles | 6 | 50 | 1.5 | 5 | 5 | 5 | 5 | 13 |
| Example 402 | 402 | Metal oxide 1 | Silica-coated acrylic resin particles | 6 | 50 | 1.5 | 5 | 5 | 5 | 5 | 13 |

From the results listed in Table I, it was understood that the on-press development type blank plate precursor 401 for printing and the development treatment type blank plate precursor 402 for printing respectively having the back coat layer containing a specific metal oxide and specific fine particles according to the present invention were excellent in all evaluations of the mat dropping, the adhesiveness, the scratches, and the scars and dislocation in stacking precursors did not occur even in a case where the lamination was made without interleaving paper.

[Example 501]

A planographic printing plate was prepared by performing the following image exposure and the development treatment on the planographic printing plate precursor 101.

(Image exposure)

The planographic printing plate precursor was set by Trendsetter 3244 (manufactured by Creo Co., Ltd.) and then image-exposed under conditions of resolution of 2400 dpi, an output of 7 W, an external surface drum rotation speed of 150 rpm, and a plate surface energy of 110 $mJ/cm^2$.

(Development treatment)

The image-exposed planographic printing plate precursor was subjected to a development treatment using an automatic developing device 1 illustrated in Fig. 1. In other words, in a development treatment unit 10, a planographic printing plate was prepared by sequentially performing a development treatment step of removing an unexposed portion in the image recording layer using the following developer (A); a washing step of washing the developed planographic printing plate with water in a washing unit 16; and a desensitizing step of applying the following desensitizing treatment liquid to the water-washed planographic printing plate in a desensitizing treatment unit 18.

Here, the automatic developing device 1 serving as an example of an automatic developing device will be simply described with reference to Fig. 1.

The automatic developing device 1 illustrated in Fig. 1 includes the development treatment unit 10; the developing unit 14 which is continuously formed along the transport direction (arrow A) of the planographic printing plate precursor in a transport path 12; the washing unit 16; the desensitizing treatment unit 18; and a drying unit 20.

The developing unit 14 is partitioned by a skin panel 111, and a slit-like insertion opening 112 is provided in the skin panel 111.

A development tank 24 filled with a developer and a pair of insertion rollers 241 guiding a planographic printing plate precursor to the inside of the development tank 24 are provided in the developing unit 14. The upper portion of the development tank 24 is covered by a shielding lid 242.

In the development tank 24, a guide roller 143, a guide member, a brush roller 141, a submerged transport roller 144, a brush roller 142, and a developing unit exit roller 56 are arranged side by side in this order from the upstream side in the transport direction. A planographic printing plate precursor transported to the inside of the development tank 24 is immersed in the developer and passes through the rotating brush rollers 141 and 142. In this manner, a non-image portion is removed.

In the planographic printing plate transported from the development tank 24, wash water is supplied to the washing unit 16 by a washing spray 66, the developer remaining on the plate surface or the like is washed and removed, and a desensitizing treatment liquid is supplied to the plate surface by a gum liquid (desensitizing treatment liquid) supply spray 72 in the desensitizing treatment unit 18.

The slit-like insertion opening 202 is provided in a partition plate 201 disposed between the development treatment unit 10 and the drying unit 20. Further, a shutter (not illustrated) is provided on a passage between the development treatment unit 10 and the drying unit 20, and the passage is closed by the shutter during the planographic printing plate precursor not passing through the passage.

A support roller 203, a duct 204, a pair of transport rollers 205, a duct 206, and a pair of transport rollers 208 are provided in the drying unit 20 in this order. A slit hole is provided at each tip of the ducts 204 and 205. Further, drying means (drying member) such as hot air supply means (hot air supply member) or heat generation means (heat generation member) (not illustrated) is provided in the drying unit 20. A discharge port 209 is provided in the drying unit 20 so that the dried planographic printing plate is discharged from the discharge port 209 by the drying means.

<Developer (A)>

- Non-ionic surfactant (polyoxyethylene naphthalene ether (NEWCOL B13, manufactured by Nippon Nyukazai Co., Ltd., solid content of 100%)) 5.0 % by mass
- Chelating agent ((ethylenediamine disuccinic acid trisodium salt (CHELEST EDDS-35, manufactured by Chelest Corporation) 0.5% by mass
- Silicone-based antifoaming agent (TSA739, manufactured by Momentive Performance Materials Japan LLC, Ltd.) 0.1% by mass
- Preservative (Acticide LA1206, manufactured by THOR JAPAN, Ltd.) 0.1% by mass

The total amount thereof was set to 100% by mass by adding water (pH: 9.4).
The conditions for the development treatment are as follows.

Temperature of developer: 25°C
Transport speed: 100 cm/min
Brush rotation speed of developing unit: 100 rpm
Condition for supplying water to washing unit: water (25°C, supply amount: 10 L/min)
Desensitizing treatment liquid: gum liquid (FN-6, manufactured by Fujifilm Corporation)/tap water = 1/1 (pH: 3.5)
Temperature of desensitizing treatment liquid: 25°C
Time for desensitizing treatment liquid passing through tank: 10 L/min)

According to the present invention, it is possible to provide a printing plate precursor which is capable of preventing dislocation in stacking precursors, adhesion between precursors, and scratches even without interleaving paper in a case where printing plate precursors respectively including a planographic printing plate precursor and a blank plate precursor are laminated; and a laminate of the printing plate precursors.
According to the present invention, it is possible to provide a planographic printing plate or a blank plate for printing prepared using the printing plate precursor; and a laminate of the planographic printing plates or the blank plates for printing.
The present invention has been described with reference to detailed and specific embodiments, but various changes or modifications can be made without departing from the spirit and the scope of the present invention and this is apparent to those skilled in the art.
The present application is based on Japanese Patent Application (JP2015-132081) filed on June 30, 2015 and the contents of which are incorporated herein by reference. Explanation of References
1: automatic developing device
14: development treatment unit
16: washing unit
18: desensitizing treatment unit

## Claims

1. A printing plate precursor comprising:

   a support;
   a layer which contains a polymer on one side of the support; and
   a layer which contains a metal oxide obtained by hydrolyzing and polycondensing an organic metal compound or an inorganic metal compound and fine particles on other side of the support,
   wherein an average particle diameter of the fine particles is 0.3 μm or greater and is greater than a thickness of the layer containing the metal oxide and the fine particles.

2. The printing plate precursor according to claim 1,
   wherein the fine particles are fine particles having a hydrophilic surface.

3. The printing plate precursor according to claim 2,
   wherein the fine particles having a hydrophilic surface are at least one selected from organic resin fine particles having a hydrophilic surface and inorganic fine particles having a hydrophilic surface.

4. The printing plate precursor according to claim 3,

wherein the organic resin fine particles having a hydrophilic surface are organic resin fine particles coated with at least one inorganic compound selected from silica, alumina, titania, and zirconia.

**5.** The printing plate precursor according to claim 3 or 4,
wherein the organic resin fine particles having a hydrophilic surface are organic resin fine particles coated with silica.

**6.** The printing plate precursor according to any one of claims 3 to 5,
wherein an organic resin constituting the organic resin fine particles having a hydrophilic surface is at least one resin selected from a polyacrylic resin, a polyurethane resin, a polystyrene resin, a polyester resin, an epoxy resin, a phenolic resin, and a melamine resin.

**7.** The printing plate precursor according to any one of claims 1 to 6,
wherein the layer containing the polymer is a positive image recording layer containing an infrared absorbent.

**8.** The printing plate precursor according to any one of claims 1 to 6,
wherein the layer containing the polymer is a negative image recording layer containing an infrared absorbent, a polymerization initiator, and a polymerizable compound.

**9.** The printing plate precursor according to any one of claims 1 to 6,
wherein the layer containing the polymer is a negative image recording layer containing an infrared absorbent, a polymerization initiator, a polymerizable compound, and a polymer compound having a fine particle shape.

**10.** The printing plate precursor according to any one of claims 1 to 6,
wherein the layer containing the polymer is a negative image recording layer containing an infrared absorbent and thermoplastic polymer fine particles.

**11.** The printing plate precursor according to any one of claims 7 to 10,
wherein the layer containing the polymer is removable by at least any of printing ink and dampening water.

**12.** The printing plate precursor according to any one of claims 1 to 6,
wherein the layer containing the polymer is a non-photosensitive layer.

**13.** The printing plate precursor according to claim 12,
wherein the layer containing the polymer is removable by at least any of printing ink and dampening water.

**14.** A planographic printing plate which is prepared using the printing plate precursor according to any one of claims 1 to 11.

**15.** A blank plate for printing which is prepared using the printing plate precursor according to claim 12 or 13.

**16.** A laminate which is formed by bringing a plurality of the printing plate precursors according to any one of claims 1 to 11 into direct contact with each other to laminate the printing plate precursors.

**17.** A laminate which is formed by bringing a plurality of the printing plate precursors according to claim 12 or 13 into direct contact with each other to laminate the printing plate precursors.

**18.** A laminate which is formed by bringing a plurality of the planographic printing plates according to claim 14 into direct contact with each other to laminate the planographic printing plates.

**19.** A laminate which is formed by bringing a plurality of the blank plates for printing according to claim 15 into direct contact with each other to laminate the blank plates for printing.

FIG. 1

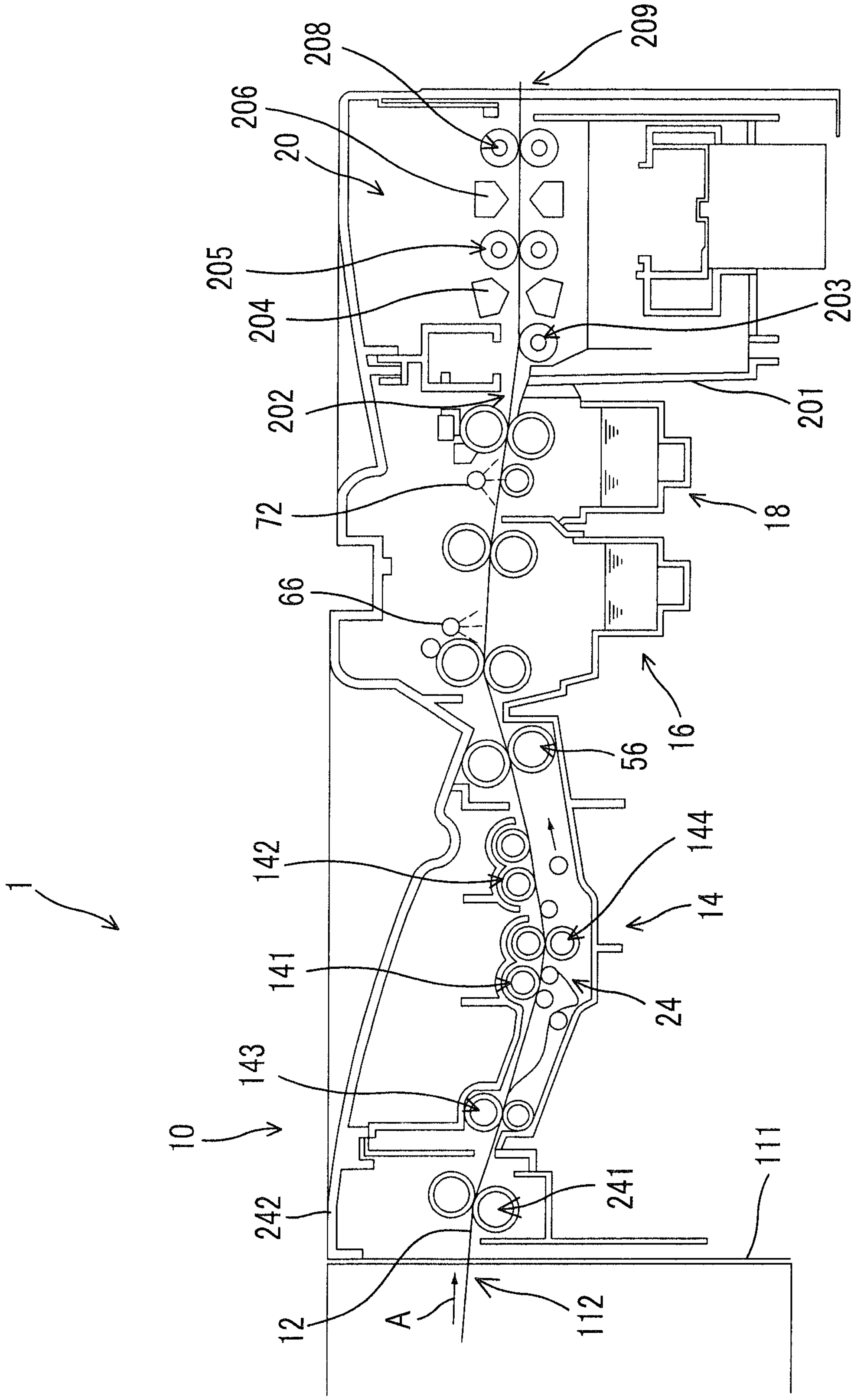
209
208
206
20
205
204
203
202
201
72
18
66
16
56
1
142
144
14
141
24
143
10
242
241
111
12
A
112

## INTERNATIONAL SEARCH REPORT

International application No.
PCT/JP2016/068061

A. CLASSIFICATION OF SUBJECT MATTER
*B41N1/14*(2006.01)i, *B41N1/00*(2006.01)i, *G03F7/00*(2006.01)i, *G03F7/09*(2006.01)i

According to International Patent Classification (IPC) or to both national classification and IPC

B. FIELDS SEARCHED

Minimum documentation searched (classification system followed by classification symbols)
B41N1/14, B41N1/00, G03F7/00, G03F7/09

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2016 |
| Kokai Jitsuyo Shinan Koho | 1971-2016 | Toroku Jitsuyo Shinan Koho | 1994-2016 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2008-15503 A (Fujifilm Corp.), 24 January 2008 (24.01.2008), entire text & US 2007/0287095 A1 entire text & EP 1865380 A1 | 1-19 |
| A | JP 2006-327136 A (Konica Minolta Medical & Graphic, Inc.), 07 December 2006 (07.12.2006), entire text (Family: none) | 1-19 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 25 August 2016 (25.08.16) | 06 September 2016 (06.09.16) |

| Name and mailing address of the ISA/ | Authorized officer |
|---|---|
| Japan Patent Office<br>3-4-3,Kasumigaseki,Chiyoda-ku,<br>Tokyo 100-8915,Japan | Telephone No. |

Form PCT/ISA/210 (second sheet) (January 2015)

INTERNATIONAL SEARCH REPORT

International application No.
PCT/JP2016/068061

C (Continuation). DOCUMENTS CONSIDERED TO BE RELEVANT

| Category* | Citation of document, with indication, where appropriate, of the relevant passages | Relevant to claim No. |
|---|---|---|
| A | JP 2006-281422 A (Konica Minolta Medical & Graphic, Inc.), 19 October 2006 (19.10.2006), entire text; all drawings (Family: none) | 1-19 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2007148040 A
- JP 2006056185 A
- JP 2008249851 A
- JP 2008015503 A
- JP 2002327036 A
- JP 2002173410 A
- JP 2004307837 A
- JP 2006038246 A
- JP 6234284 A
- JP H06234284 A
- JP 2014104631 A
- JP 2008195018 A
- JP 2012148555 A
- JP 2007276454 A
- JP 2009154525 A
- JP 2008284817 A
- JP 2006091479 A
- US 20080311520 A
- JP 9123387 A
- JP H09123387 A
- JP 9131850 A
- JP H09131850 A
- JP 9171249 A
- JP H09171249 A
- JP 9171250 A
- JP H09171250 A
- EP 931647 B
- JP 2001277740 A
- JP 2001277742 A
- WO 9634316 A
- JP 62170950 A
- JP S62170950 A
- JP 10282679 A
- JP H10282679 A
- JP 2304441 A
- JP H02304441 A
- JP 2005125749 A
- JP 2006188038 A
- JP 2001253181 A
- JP 2001322365 A
- US 2714066 A
- US 3181461 A
- US 3280734 A
- US 3902734 A
- US 3276868 A
- US 4153461 A
- US 4689272 A
- JP 2011218778 A
- US 3458311 A
- JP 55049729 A
- JP S5549729 A
- JP 2015132081 A


### Non-patent literature cited in the description


- Ultrafine Particles and Materials. SHOKABO Co., Ltd, 1993
- **HARUMA KAWAGUCHI.** Preparation and Application of Fine Particles and Powder. CMC Publishing Co., Ltd, 2005
- Latest Pigment Application Technology. CMC Publishing Co., Ltd, 1986
- Infrared Absorbind Dyes'' of ''Chemical Industry. Dye Handbook. 1970, 45-51
- Development and Market Trend of Functional Dyes in 1990's. CMC Publishing Co., Ltd, 1990
- Latest Pigment Application Technology. Latest Pigment Handbook. CMC Publishing Co., Ltd, 1977
- Printing Ink Technology. CMC Publishing Co., Ltd, 1984